(19) **Europäisches Patentamt**
**European Patent Office**
**Office européen des brevets**

(11) **EP 3 900 193 B1**

(12) **FASCICULE DE BREVET EUROPEEN**

(45) Date de publication et mention de la délivrance du brevet:
**12.04.2023  Bulletin 2023/15**

(21) Numéro de dépôt: **19839650.9**

(22) Date de dépôt: **12.12.2019**

(51) Classification Internationale des Brevets (IPC):
**H03M 13/29** (2006.01)    **H04L 1/00** (2006.01)

(52) Classification Coopérative des Brevets (CPC):
**H03M 13/2969; H04L 1/0058; H04L 1/0066**

(86) Numéro de dépôt international:
**PCT/FR2019/053048**

(87) Numéro de publication internationale:
**WO 2020/128248 (25.06.2020 Gazette 2020/26)**

(54) **PROCÉDÉ DE GÉNÉRATION D'UN SIGNAL METTANT EN OEUVRE UN TURBO-CODEUR, DISPOSITIF ET PROGRAMME D'ORDINATEUR CORRESPONDANTS**

VERFAHREN ZUR ERZEUGUNG EINES SIGNALS MITTELS TURBOCODIERER UND ZUGEHÖRIGE VORRICHTUNG UND COMPUTERPROGRAMM

METHOD FOR GENERATING A SIGNAL BY MEANS OF A TURBO-ENCODER, AND CORRESPONDING DEVICE AND COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2018  FR 1873615**

(43) Date de publication de la demande:
**27.10.2021  Bulletin 2021/43**

(73) Titulaire: **Orange**
**92130 Issy-les-Moulineaux (FR)**

(72) Inventeurs:
- **KLAIMI, Rami**
  **92326 CHÂTILLON CEDEX (FR)**
- **DOUILLARD, Catherine**
  **92326 CHÂTILLON CEDEX (FR)**
- **ABDEL NOUR, Charbel**
  **92326 CHÂTILLON CEDEX (FR)**

(74) Mandataire: **Vidon Brevets & Stratégie**
**16B, rue de Jouanet**
**BP 90333**
**35703 Rennes Cedex 7 (FR)**

(56) Documents cités:
- **MATSUMINE TOSHIKI ET AL: "Capacity-Approaching Non-Binary Turbo Codes: A Hybrid Design Based on EXIT Charts and Union Bounds", IEEE ACCESS, vol. 6, 14 novembre 2018 (2018-11-14), pages 70952-70963, XP011699389, DOI: 10.1109/ACCESS.2018.2881243**
- **KLAIMI RAMI ET AL: "Design of Low-Complexity Convolutional Codes over GF(q)", 2018 IEEE GLOBAL COMMUNICATIONS CONFERENCE (GLOBECOM), IEEE, 9 décembre 2018 (2018-12-09), pages 1-7, XP033519983, DOI: 10.1109/GLOCOM.2018.8647824**

**Description**

**1. Domaine de l'invention**

Le domaine de l'invention est celui des communications numériques, mettant en oeuvre un code correcteur d'erreur de type turbo-code.

En particulier, l'invention propose une nouvelle technique de génération d'un signal mettant en oeuvre un code correcteur d'erreur de type turbo-code non binaire.

L'invention trouve notamment des applications dans le domaine des communications sans fil (DAB, DVB-T, WLAN, optique non guidée, etc.) ou filaires (xDSL, PLC, optique, etc.).

**2. Art antérieur**

2.1 Turbo-codeurs binaires

Les codes correcteurs d'erreurs classiquement utilisés dans les systèmes de communications numériques sont binaires. En d'autres termes, les symboles d'information en entrée du codeur, et les symboles de redondance obtenus en sortie du codeur, sont des éléments binaires, appartenant au corps de Galois GF(2).

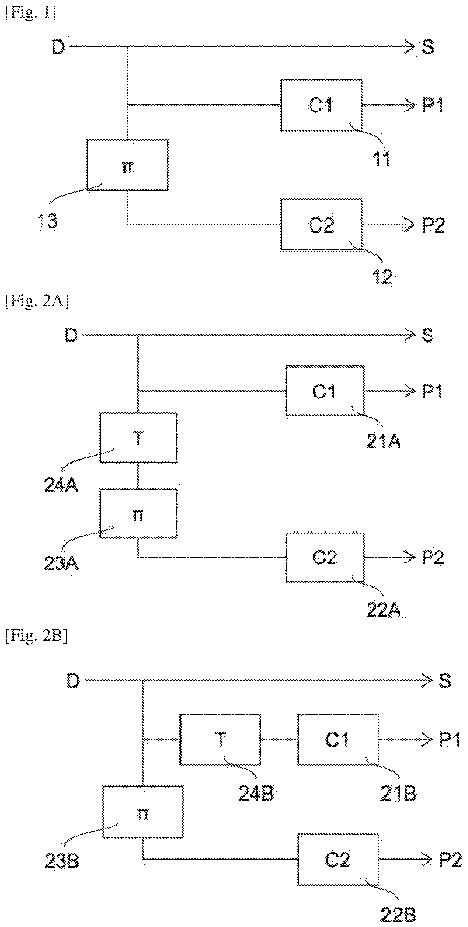

La structure conventionnelle d'un turbo-codeur binaire, illustrée en figure 1, comprend la concaténation parallèle de deux codeurs, par exemple de type convolutifs systématiques récursifs, C1 11 et C2 12, séparés par un entrelaceur 13. Le message numérique d'entrée D, formé de K symboles d'information définis sur GF(2), est codé dans l'ordre d'arrivée des symboles d'information, dit ordre naturel, par le premier codeur C1 11, et dans un ordre entrelacé, ou permuté, par le deuxième codeur C2 12. Le message numérique de sortie comprend des symboles systématiques S, correspondant aux K symboles d'information, et des symboles de parité ou de redondance P1 et P2, définis sur GF(2).

2.2 Turbo-codeurs non binaires

Des codes correcteurs d'erreurs peuvent également être définis sur des corps de Galois de cardinal q plus élevé que 2, GF(q). La structure d'un turbo-codeur non binaire est similaire à la structure d'un turbo-codeur binaire. Dans ce cas, le message numérique d'entrée D est formée de K symboles d'information définis sur GF(q), et le message numérique de sortie est formé de symboles systématiques S, correspondant aux K symboles d'information, et de symboles de parité ou de redondance P1 et P2, définis sur GF(q).

Ces codes correcteurs d'erreurs non binaires peuvent être associés à une modulation d'ordre p égal à q (par exemple une modulation d'amplitude en quadrature q-QAM) ou à une modulation d'ordre différent. En particulier, le pouvoir de correction des codes non binaires est supérieur au pouvoir de correction des codes binaires lorsque ces codes sont associés à une modulation de même ordre, p égal à q (par exemple q-QAM).

Une différence entre les codes binaires et non binaires du point de vue du pouvoir de correction est que les performances à faible taux d'erreur d'un code binaire sont dictées par sa distance minimale de Hamming, tandis que les performances à faible taux d'erreur d'un code non binaire sont dictées par la distance euclidienne cumulée minimale entre deux séquences codées (i.e. deux messages de sortie du turbo-codeur), qui tient compte de la constellation de la modulation p-aire utilisée.

Lorsqu'il est associé à une modulation de même ordre p=q (par exemple q-QAM), le pouvoir de correction à fort rapport signal à bruit sur un canal à bruit additif gaussien d'un code convolutif non binaire défini sur GF(q), en termes de taux d'erreurs paquets (TEP ou FER pour « Frame Error rate » en anglais) est donné par la borne de l'union (UB pour « Union Bound » en anglais):

[Equation 1]

$$TEP \leq UB = \frac{1}{C_{q^K}^2} \sum_{d=d_{min}}^{d_{max}} n(d) Q\left(\frac{d}{2\sigma}\right)$$

où K est la longueur des messages numériques d'entrée,

$C_{q^K}^2$ est le nombre de combinaisons de couples de messages numériques d'entrée de longueur K,

$d_{min}$ est la distance euclidienne cumulée minimale entre deux messages de sortie (ou mots de code),

$n(d)$ est la multiplicité associée à la distance $d$, c'est-à-dire le nombre de couples de mots de code à la distance $d$

les uns des autres,

σ est la variance du bruit gaussien, et

$Q(\cdot)$ désigne la fonction d'erreur : $Q(x) = \frac{1}{\sqrt{2\pi}} \int_x^\infty e^{-t^2/2} dt$ .

La valeur de la borne UB est dominée par ses premiers termes, correspondant aux valeurs faibles de la distance $d$, à savoir $d_{min}$ et les valeurs juste supérieures. Le document "Capacity-Approaching Non-Binary Turbo Codes: A Hybrid Design Based on EXIT Charts and Union Bounds", Toshiki et al., IEEE Access vol. 6, 2018, XP011699389, considère l'optimisation des codes convolutifs d'un turbo-codeur non-binaire, au critère de la distance de spectre. Le document "Design of Low-Complexity Convolutional Codes over GF(q)", Rami et al., IEEE Globecom 2018, XP033519983, considère l'optimisation du mappage et des codes convolutifs pour les turbo codeurs non-binaires, sur le critère de la somme des distances Euclidiennes entre symboles.

## 3. Exposé de l'invention

Afin d'améliorer les performances des turbo-codes, notamment des turbo-codes non binaires, il est souhaitable d'augmenter la distance entre les messages de sortie. Par exemple, il est souhaitable d'augmenter la distance euclidienne cumulée minimale entre deux mots de code par rapport à l'art antérieur.

Pour ce faire, l'invention propose un procédé de génération d'un signal, comprenant une étape de turbo-codage d'un ensemble de symboles d'information délivrant d'une part les symboles d'information et d'autre part des symboles de redondance, mettant en oeuvre, pour l'obtention des symboles de redondance :

- un codage dudit ensemble de symboles d'information par un premier codeur, délivrant un premier ensemble de symboles de redondance,
- un entrelacement dudit ensemble de symboles d'information, délivrant un ensemble de symboles d'information entrelacés,
- un codage dudit ensemble de symboles d'information entrelacés par un deuxième codeur, délivrant un deuxième ensemble de symboles de redondance.

Selon l'invention, l'étape de turbo-codage met également en oeuvre une transformation bijective desdits symboles d'information, mise en oeuvre avant et/ou après ledit entrelacement, ladite transformation modifiant la valeur d'au moins deux desdits symboles d'information préalablement au codage desdits symboles d'information par le premier et/ou le deuxième codeur.

En d'autre terme, l'invention propose une modification de la structure conventionnelle des turbo-codeurs, reposant sur l'ajout d'une fonction de transformation des symboles d'information avant le codage du message d'entrée par le premier codeur ou par le deuxième codeur, et mise en oeuvre indifféremment avant ou après l'entrelacement.

De cette façon, on change d'une part l'ordre des symboles d'information entrant sur les deux codeurs, grâce à l'entrelacement, et d'autre part la valeur des symboles d'information entrant sur les deux codeurs, grâce à la transformation. Les séquences codées obtenues en sortie des deux codeurs ne sont donc pas constituées des mêmes symboles d'information et de redondance.

La transformation considérée est une bijection sur l'ensemble des symboles du corps de Galois considéré : chaque symbole de GF($q$) a une image unique dans GF($q$) par cette transformation et tout élément de GF($q$) a un antécédent unique dans GF($q$). Une telle transformation modifie donc la valeur d'au moins deux symboles d'information.

A titre d'exemple, si les symboles d'information appartiennent au corps de Galois GF(2) et si l'on considère un ensemble de symboles d'information formant le message d'entrée 000000100, l'ensemble de symboles d'information entrelacés peut être 010000000 avant transformation, et 101111111 après transformation (la transformation bijective transformant, dans ce cas, les symboles d'information de valeur « 0 » en symboles d'information de valeur « 1 » et vice versa). On peut donc changer à la fois l'ordre et la valeur des symboles d'information entrants sur les deux codeurs du turbo-codeur.

Cette transformation a pour objectif global d'augmenter la distance cumulée minimale entre deux mots de code, par exemple la distance euclidienne cumulée, par rapport à au turbo-codeur sans transformation, indépendamment de la nature des codes élémentaires mis en oeuvre par les premier et deuxième codeurs et de l'entrelaceur utilisés.

On propose ainsi une solution permettant, selon au moins un mode de réalisation, d'améliorer le pouvoir de correction du turbo-décodeur.

En particulier, les symboles d'information appartiennent à un corps de Galois de cardinal q, noté GF(q), avec q>2. En effet, la mise en oeuvre d'une fonction de transformation permet notamment d'améliorer les performances de correction des turbo-codes non binaires.

Selon un mode de réalisation particulier, la transformation génère une dispersion minimale $\Delta_{min}$ entre deux symboles d'information $S_i$, $S_j$ parmi lesdits symboles d'information supérieure à un seuil de sélection, telle que :

$$\Delta_{min} = \min \Delta\big(S_i, S_i\big)$$

avec :

$$\Delta\big(S_i, S_j\big) = D\big(S_i, S_j\big) + D\big(T(S_i), T(S_j)\big)$$

$D(S_i, S_j)$ la distance entre lesdits symboles d'information $S_i$, $S_j$ avant transformation,
$D(T(S_i), T(S_j))$ la distance entre lesdits symboles d'information $S_i$, $S_j$ après transformation par la fonction T.

En d'autres termes, la solution proposée cherche à maximiser l'écart cumulé entre les symboles d'information avant transformation et les symboles d'information après transformation.

Selon un mode de réalisation particulier, le procédé met en oeuvre une étape de mappage des symboles d'information et de redondance sur des symboles de modulation associés à une constellation d'ordre p, un symbole d'information ou de redondance étant mappé sur au moins un symbole de modulation, et la transformation tient compte de ladite constellation.

En particulier, la transformation tient compte de la position des symboles de modulation associés aux symboles d'information avant et après transformation, et cherche à augmenter la distance euclidienne entre ces symboles de modulation par rapport à une mise en oeuvre sans transformation.

Selon un premier exemple de réalisation, l'ordre p de la constellation étant égal au cardinal q du corps de Galois auquel appartiennent les symboles d'information, chaque symbole d'information ou de redondance est mappé sur un unique symbole de modulation.

Selon ce premier exemple, la dispersion entre deux symboles d'information $S_i$, $S_j$ s'exprime sous la forme :

$$\Delta\big(S_i, S_j\big) = d_{euc}^2\big(S_i^m, S_j^m\big) + d_{euc}^2\big(T(S_i)^m, T(S_j)^m\big)$$

avec :

$$d_{euc}^2\big(S_i^m, S_j^m\big) = \Big(I_{S_i^m} - I_{S_j^m}\Big)^2 + \Big(Q_{S_i^m} - Q_{S_j^m}\Big)^2$$ le carré de la distance euclidienne entre les symboles de modulation $S_i^m$, $S_j^m$ sur lesquels sont mappés lesdits symboles d'information $S_i$, $S_j$ avant transformation ;

$$d_{euc}^2\big(T(S_i)^m, T(S_j)^m\big) = \Big(I_{T(S_i)^m} - I_{T(S_j)^m}\Big)^2 + \Big(Q_{T(S_i)^m} - Q_{T(S_j)^m}\Big)^2$$ le carré de la distance euclidienne entre les symboles de modulation $T(S_i)^m$, $T(S_j)^m$ sur lesquels sont mappés lesdits symboles d'information $S_i$, $S_j$ après transformation ; et

$I_x$ et $Q_x$ les composantes en phase et en quadrature d'un signal x dans la constellation considérée.

En d'autres termes, la distance $D(S_i, S_j)$ entre les symboles d'information $S_i$, $S_j$ avant transformation, et la distance $D(T(S_i), T(S_j)$ entre les symboles d'information $T(S_i)$, $T(S_j)$ après transformation, s'expriment sous la forme de distance euclidienne au carré.

Selon un premier critère de construction de la fonction de transformation, la transformation transforme un couple de symboles d'information destinés à être mappés sur un couple de symboles de modulation dont la distance euclidienne est inférieure à un premier seuil, en un couple de symboles d'information destinés à être mappés sur un couple de symbole de modulation dont la distance euclidienne est supérieure au premier seuil, et inversement.

Selon un deuxième critère de construction de la fonction de transformation, qui peut être pris individuellement ou en combinaison avec le premier critère, la transformation transforme un symbole d'information destiné à être mappé sur un symbole de modulation présentant, dans la constellation, un nombre de symboles de modulation voisins inférieur à un nombre déterminé, en un symbole d'information destiné à être mappé sur un symbole de modulation présentant, dans la constellation, un nombre de voisins supérieur audit nombre déterminé, et inversement.

Le procédé peut également mettre en oeuvre une étape de sélection d'une transformation parmi plusieurs transformations disponibles, ladite sélection tenant compte desdits symboles de redondance et/ou dudit entrelaceur.

Dans ce cas, la sélection peut faire appel à des propriétés du treillis représentatif du turbo-code.

Selon un deuxième exemple de réalisation, l'ordre *p* de la constellation étant inférieur au cardinal q du corps de Galois auquel appartiennent lesdits symboles d'information, chaque symbole d'information ou de redondance est mappé sur *n* symboles de modulation, avec $n \geq 2$.

Selon ce deuxième exemple, la dispersion entre deux symboles d'information $S_i$, $S_j$ s'exprime sous la forme :

$$\Delta(S_i, S_j) = D(S_i, S_j) + D(T(S_i), T(S_j))$$

avec :

$$D(S_i, S_j) = \sum_{k=1}^{n} d_{euc}^2(S_{i,k}^m, S_{j,k}^m) = \sum_{k=1}^{n} \left[ \left( I_{S_{i,k}^m} - I_{S_{j,k}^m} \right)^2 + \left( Q_{S_{i,k}^m} - Q_{S_{j,k}^m} \right)^2 \right]$$

$$\begin{aligned} D(T(S_i), T(S_j)) &= \sum_{k=1}^{n} d_{euc}^2(T(S_i)_k^m, T(S_j)_k^m) \\ &= \sum_{k=1}^{n} \left[ \left( I_{T(S_i)_k^m} - I_{T(S_j)_k^m} \right)^2 + \left( Q_{T(S_i)_k^m} - Q_{T(S_j)_k^m} \right)^2 \right] \end{aligned}$$

$S^m_{i,k}$ respectivement $S^m_{j,k}$, pour k allant de 1 à n, les *n* symboles de modulation associés au symbole d'information $S_i$, respectivement $S_j$, avant transformation, $T(S_i)_k^m$, respectivement $T(S_j)_k^m$, pour k allant de 1 à n, les *n* symboles de modulation associés au symbole d'information $S_i$, respectivement $Sj$, après transformation,

$I_x$ et $Q_x$ les composantes en phase et en quadrature d'un signal x dans la constellation considérée.

Selon un premier critère de construction de la fonction de transformation, la transformation minimise le nombre de termes nuls dans l'expression de la dispersion $\Delta(S_i, S_j)$.

Le procédé peut également mettre en oeuvre une étape de sélection d'une transformation parmi plusieurs transformations disponibles, ladite sélection maximisant la valeur des termes non nuls dans l'expression de la dispersion $\Delta(S_i, S_j)$.

Selon un mode de réalisation, le premier codeur met en oeuvre au moins un premier code élémentaire et le deuxième codeur met en oeuvre au moins un deuxième code élémentaire, distinct dudit premier code élémentaire. Le turbo-codeur peut ainsi utiliser des codes élémentaires présentant un pouvoir de correction différent.

Selon un autre mode de réalisation, les premier et deuxième codes élémentaires sont identiques.

L'invention concerne par ailleurs un dispositif de génération d'un signal correspondant, comprenant un turbo-encodeur apte à encoder un ensemble de symboles d'information et délivrer d'une part lesdits symboles d'information et d'autre part des symboles de redondance, ledit turbo-encodeur comprenant :

- un premier codeur pour coder ledit ensemble de symboles d'information, délivrant un premier ensemble de symboles de redondance,
- un entrelaceur pour entrelacer ledit ensemble de symboles d'information, délivrant un ensemble de symboles d'information entrelacés,
- un deuxième codeur pour coder ledit ensemble de symboles d'information entrelacés, délivrant un deuxième ensemble de symboles de redondance,

Le turbo-encodeur comprend également un processeur pour appliquer une transformation bijective auxdits symboles d'information, mise en oeuvre avant et/ou après ledit entrelaceur, ladite transformation modifiant la valeur d'au moins deux desdits symboles d'information préalablement au codage desdits symboles d'information par le premier et/ou le deuxième codeur.

Un tel dispositif de génération d'un signal est notamment adapté à mettre en oeuvre le procédé de génération décrit précédemment. Il s'agit par exemple d'un turbo-codeur binaire ou non binaire. Ce dispositif pourra bien sûr comporter les différentes caractéristiques relatives au procédé de génération selon l'invention, qui peuvent être combinées ou prises isolément. Ainsi, les caractéristiques et avantages de ce dispositif sont les mêmes que ceux du procédé décrit précédemment. Par conséquent, ils ne sont pas détaillés plus amplement.

L'invention concerne encore un ou plusieurs programmes d'ordinateur comportant des instructions pour la mise en oeuvre d'un procédé de génération d'un signal tel que décrit ci-dessus lorsque ce ou ces programmes sont exécutés par au moins un processeur.

L'invention concerne aussi un support d'informations lisible par un ordinateur, et comportant des instructions d'un programme d'ordinateur tel que mentionné ci-dessus.

## 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

[Fig 1] La figure 1 illustre une structure d'un turbo-codeur selon l'art antérieur.

[Fig 2A]

[Fig 2B] Les figures 2A et 2B illustrent deux exemples de turbo-codeur selon différents modes de réalisation de l'invention.

[Fig 3A]

[Fig 3B] Les figures 3A et 3B illustrent respectivement la structure générique d'un codeur convolutif à un élément mémoire sur GF(q), et un exemple de treillis d'un tel code.

[Fig 4] La figure 4 présente quelques séquences DC d'un treillis de code.

[Fig 5] La figure 5 illustre une constellation associée à une modulation d'amplitude à 64 états.

[Fig 6] La figure 6 illustre les points de la constellation de la figure 5 qui subissent le moins d'interférences.

[Fig 7A]

[Fig 7B]

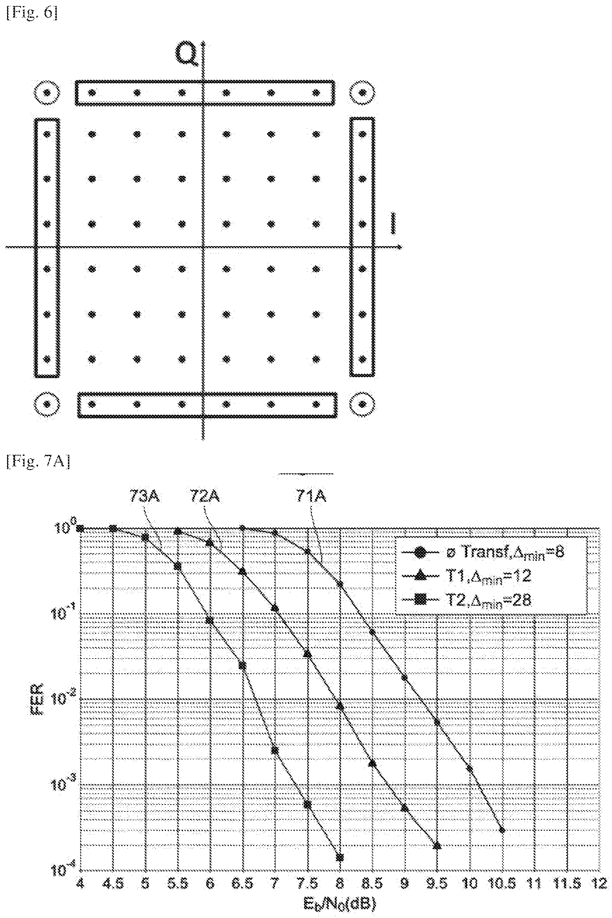

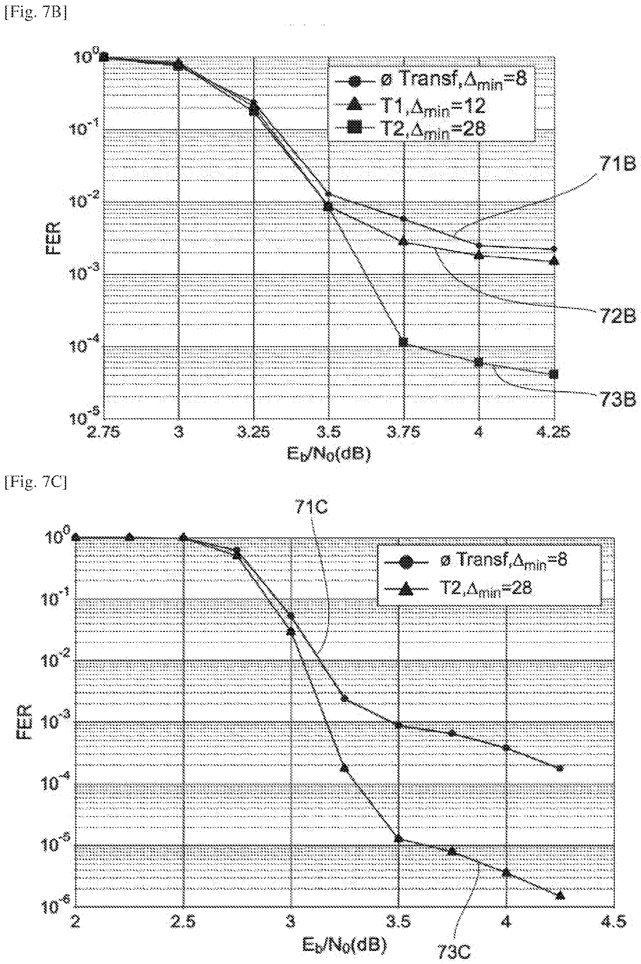

[Fig 7C] Les figures 7A à 7C comparent les performances de correction d'un turbo-code selon un mode de l'invention avec un turbo-code selon l'art antérieur, lorsque l'ordre de la modulation et du turbo-code sont identiques.

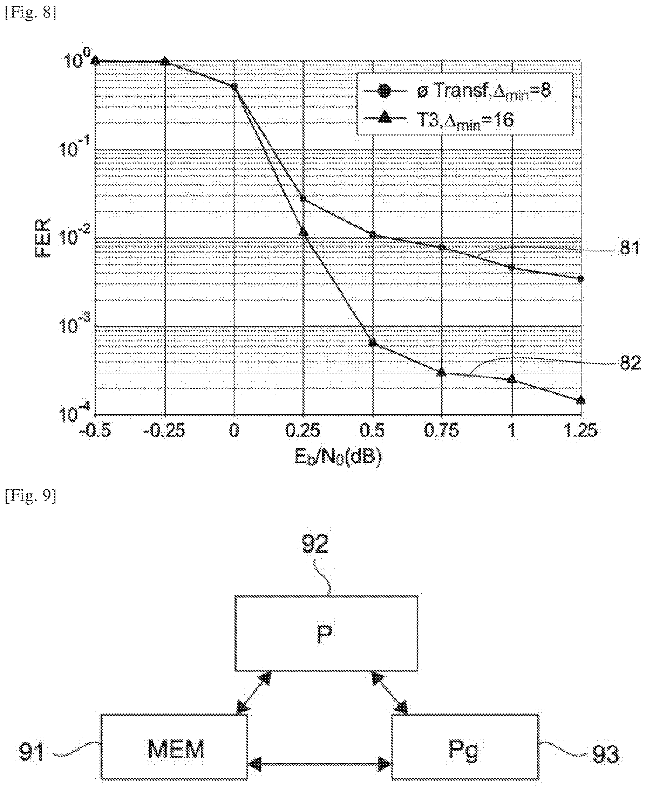

[Fig 8] La figure 8 compare les performances de correction d'un turbo-code selon un mode de l'invention avec un turbo-code selon l'art antérieur, lorsque l'ordre de la modulation et du turbo-code sont différents.

[Fig 9] La figure 9 présente la structure simplifiée d'un dispositif mettant en oeuvre une technique de génération d'un signal selon un mode de réalisation de l'invention.

## 5. Description d'un mode de réalisation de l'invention

### 5. 1 Principe général

Le principe général de l'invention repose sur l'ajout d'une fonction de transformation des symboles d'information dans un turbo-codeur, en particulier un turbo-codeur « non binaire », permettant de modifier la valeur d'au moins deux symboles d'information, de façon que la séquence entrante sur un codeur du turbo-codeur soit différente de la séquence entrante sur l'autre codeur.

Deux exemples de structures d'un turbo-codeur mettant en oeuvre l'étape de turbo-codage selon l'invention sont illustrés en figures 2A et 2B. Ces deux exemples mettent en oeuvre un premier codeur C1 21 et un deuxième codeur C2 22 en parallèle, par exemple de type convolutifs systématiques récursifs, séparés par un entrelaceur 23 et un module de transformation 24. Le message numérique d'entrée D comprend K symboles d'information, et le message numérique de sortie comprend des symboles systématiques S et des symboles de parité ou de redondance P1 et P2. Chaque séquence composée des K symboles d'information et des P1 et P2 symboles de redondance forme un mot de code.

Les symboles systématiques S correspondent aux K symboles d'information, éventuellement après entrelacement et/ou transformation.

Selon l'exemple illustré en figure 2A, le message numérique d'entrée D est codé par le premier codeur C1 21A, dans l'ordre d'arrivée des symboles d'information. Le message numérique d'entrée D est, en parallèle, transformé dans le module de transformation 24A, et les symboles d'information transformés sont entrelacés par l'entrelaceur 23A. Les symboles d'information transformés entrelacés sont ensuite codés par le deuxième codeur C2 22A.

Selon l'exemple illustré en figure 2B, le message numérique d'entrée D est transformé dans le module de transformation 24B, et les symboles d'information transformés sont codés par le premier codeur C1 21B, dans l'ordre naturel. Le message numérique d'entrée D est, en parallèle, entrelacé par l'entrelaceur 23B, puis les symboles d'information entrelacés sont codés par le deuxième codeur C2 22B.

On note que selon un autre exemple, non illustré, la transformation peut être mise en oeuvre après l'entrelacement. La transformation peut donc être mise en oeuvre indifféremment avant ou après l'entrelacement.

Selon encore un autre exemple, non illustré, une première transformation peut être mise en oeuvre avant le premier codeur, avant l'entrelaceur, et une deuxième transformation, différente de la première transformation et n'annulant pas la première transformation, peut être mise en oeuvre avant le deuxième codeur, avant ou après l'entrelacement. Dans ce cas, on considère que la fonction de transformation a deux composantes, une première composante correspondant à la première transformation et une deuxième composante correspondant à la deuxième transformation. La transformation « globale » est donc composée d'une combinaison des première et deuxième transformations.

On utilise par la suite le terme « transformation » pour couvrir ces différentes implémentations.

L'étape de turbo-codage selon l'invention met donc en oeuvre une transformation bijective des symboles d'information, mise en oeuvre avant et/ou après l'entrelacement, ladite transformation modifiant la valeur d'au moins deux des symboles d'information préalablement au codage des symboles d'information par le premier et/ou le deuxième codeur.

De cette façon, la séquence de symboles d'information entrant sur le premier codeur C1 diffère de la séquence de symboles d'information entrant sur le deuxième codeur C2, d'une part par l'ordre des symboles d'information entrant sur chaque codeur, grâce à l'entrelacement, d'autre part par la valeur des symboles d'information entrant sur chaque codeur, grâce à la transformation.

Comme indiqué précédemment, la transformation considérée est une bijection sur l'ensemble des symboles du corps de Galois considéré. A titre d'exemple, si l'on considère que les symboles d'information peuvent prendre des valeurs allant de 0 à 15, i.e. sont définis sur un corps de Galois de cardinal q=16, alors chaque symbole d'information de GF(16) a une image unique dans GF(16) par la transformation T, et tout élément de GF(16) a un antécédent unique dans GF(16). Le tableau ci-après donne un exemple de transformation bijective des symboles d'information $S_i$, définis dans GF(16), en symboles d'information $T(S_i)$, définis dans GF(16) :

[Tableau 1]

| $S_i$ | $T(S_i)$ |
|-------|----------|
| 0 | 9 |
| 1 | 5 |
| 2 | 7 |
| 3 | 4 |
| 4 | 12 |
| 5 | 11 |
| 6 | 15 |
| 7 | 1 |
| 8 | 13 |
| 9 | 3 |
| 10 | 14 |
| 11 | 10 |
| 12 | 2 |
| 13 | 0 |

## EP 3 900 193 B1

(suite)

| $S_i$ | $T(S_i)$ |
|---|---|
| 14 | 8 |
| 15 | 6 |

En particulier, si l'on considère des symboles d'information appartenant à un corps de Galois de cardinal q avec q>2, noté GF(q), l'étape de turbo-codage proposée permet d'augmenter la distance entre les symboles d'information, et, par suite, la distance minimale entre les mots de code sortant du turbo-codeur.

Selon un mode de réalisation particulier, la transformation a pour objectif global d'augmenter la distance euclidienne cumulée minimale entre deux séquences du code résultant par rapport au code sans transformation, indépendamment de la nature des codes élémentaires mis en oeuvre par les premier et deuxième codeur et de l'entrelaceur utilisés.

On note que la distance euclidienne cumulée minimale entre deux mots de code sortant du turbo-codeur dépend notamment de la constellation de la modulation utilisée pour transmettre les mots de code.

Ainsi, selon un mode de réalisation, le procédé de génération selon l'invention comprend une étape de mappage des symboles d'information et de redondance sur des symboles de modulation associés à une constellation d'ordre p.

La transformation peut ainsi être choisie en tenant compte de la constellation, et notamment de la position des symboles de modulation associés aux symboles d'information avant et après transformation.

*5.2 Identification des symboles d'information « problématiques »*

Classiquement, les turbo-codeurs non binaires utilisent des codeurs convolutifs systématiques récursifs mettant en oeuvre des codes élémentaires à un seul élément mémoire ($\nu = 1$). En effet, la complexité de décodage d'un code sur GF(q) varie en $q^\nu$, où $\nu$ est la mémoire du code, et il est donc plus facile de décoder un code présentant un seul élément mémoire.

Ces codeurs convolutifs ont la particularité d'avoir des treillis totalement connectés, c'est-à-dire que tous les états sont connectés entre eux dans le treillis du code.

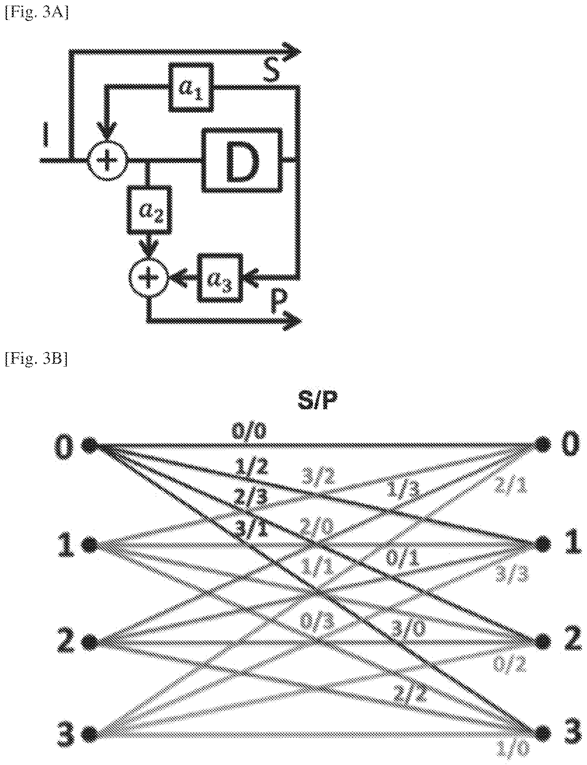

A titre d'exemple, la figure 3A illustre la structure générique d'un codeur convolutif à un élément mémoire sur GF(q), avec a1, a2, a3 des paramètres de réglage du code, D un élément mémoire, I les symboles d'information entrant, S les symboles systématiques et P les symboles de parité sortant. La figure 3B illustre un exemple de treillis pour un code défini sur GF(4), avec des valeurs particulières pour les paramètres de réglage a1, $a_2$, $a_3$, et avec des états 0 à 3.

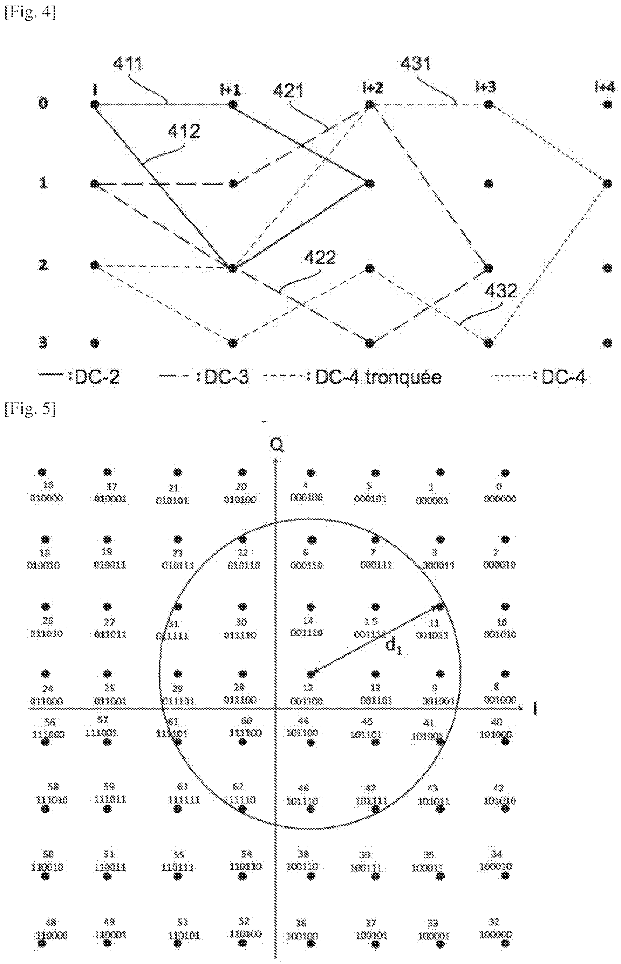

La distance euclidienne cumulée minimale d'un codeur convolutif à un élément mémoire, tel qu'illustré en figure 3A ou 3B par exemple, ainsi que les distances juste supérieures, sont causées par des séquences particulières dans le treillis qui partent d'un état donné et convergent dans un autre état, notamment les séquences les plus courtes. Ces séquences sont dites « DC » (pour divergente et convergente ou « Diverge and Converge » en anglais). Quelques exemples de séquences DC sont illustrés en figure 4 pour un code défini sur GF(4) : un exemple de séquence DC de longueur 2, un exemple de séquence DC de longueur 3 et un exemple de séquence DC de longueur 4.

Pour une paire de séquences DC, $X^1$ et $X^2$, s'étendant sur L sections de treillis (par exemple les séquences 411 et 412 s'étendant sur deux sections de treillis, les séquences 421 et 422 s'étendant sur trois séquences de treillis, ou les séquences 431 et 432 s'étendant sur quatre sections de treillis), la distance euclidienne cumulée entre les symboles de modulation associés à ces séquences est calculée comme suit :

[Equation 2]

$$d_{euc} = \sqrt{\sum_{l=1}^{L} \left[ d^2(X_{ls}^{m1}, X_{ls}^{m2}) + d^2\left(X_{lp}^{m1}, X_{lp}^{m2}\right) \right]}$$

[Equation 3]

$$d_{euc} = \sqrt{\sum_{l=1}^{L}\left[\left(I_{X_{ls}^{m1}} - I_{X_{ls}^{m2}}\right)^2 + \left(Q_{X_{ls}^{m1}} - Q_{X_{ls}^{m2}}\right)^2 + \left(I_{X_{lp}^{m1}} - I_{X_{lp}^{m2}}\right)^2 + \left(Q_{X_{lp}^{m1}} - Q_{X_{lp}^{m2}}\right)^2\right]}$$

où :

$X_{ls}^{mb}$ et $X_{lp}^{mb}$ sont respectivement les symboles de modulation sur lesquels sont mappés les symboles systématique et de parité correspondant à la section de treillis I dans la séquence $X^b$, b=1,2 et $I_x$ et $Q_x$ représentent les composantes en phase et en quadrature du signal x dans la constellation considérée.

En raison de la propriété de connexion totale du treillis, les couples de symboles systématiques S portés par les différentes sections des séquences DC $X^1$ et $X^2$, peuvent prendre toutes les combinaisons dans GF(q)xGF(q). Plus précisément, les symboles systématiques portés par les première et dernière sections de treillis des séquences DC sont nécessairement différents sur les deux séquences. Ce n'est pas le cas pour les symboles portés par les sections de treillis intermédiaires lorsque L > 2, pour lesquelles les symboles systématiques peuvent être identiques.

Les inventeurs de la présente demande de brevet ont démontré que pour cette famille de codes à ν = 1 élément mémoire, les séquences DC associées à des symboles de modulation dont la distance euclidienne cumulée par rapport à la séquence transmise est faible sont essentiellement générées par des symboles de modulation situés dans le voisinage de symboles de modulation effectivement transmis, c'est-à-dire pour lesquelles les termes suivants dans l'équation 3 sont de faible valeur :

$$\left(I_{X_{ls}^{m1}} - I_{X_{ls}^{m2}}\right)^2 + \left(Q_{X_{ls}^{m1}} - Q_{X_{ls}^{m2}}\right)^2.$$

Par exemple, si l'on considère un codeur récursif tel qu'illustré en figure 3A, défini sur GF(64), les inventeurs de la présente demande de brevet ont démontré que quelles que soient les valeurs des coefficients $a_i$, les deux termes de distances euclidiennes cumulées les plus faibles de l'UB sont obtenus pour des couples de séquences dont les symboles de modulation associés à des symboles systématiques sont distants deux à deux d'au plus la distance d1 indiquée dans la figure 5 pour une constellation 64-QAM. Autrement dit, pour un symbole systématique transmis sur un symbole de modulation donné, par exemple le symbole de modulation 12 (dont la représentation binaire est 001100) dans la constellation, les symboles systématiques concurrents les plus probables sont ceux situés dans le cercle de rayon d1 centré sur le symbole de modulation 12 dans la constellation.

*5.3 Exemples de mise en oeuvre*

Afin d'éloigner les symboles d'information transmis des symboles d'information concurrents les plus probables, et donc d'augmenter la distance euclidienne minimale entre deux mots de code en sortie du turbo-codeur, on propose selon l'invention d'introduire une transformation avant l'une des étapes de codage mise en oeuvre par le turbo-encodeur.

En particulier, la transformation maximise l'écart cumulé entre les symboles de modulation associés aux symboles d'information avant transformation et après transformation. Par suite, maximiser l'écart cumulé entre les symboles de modulation associés aux symboles d'information avant transformation et après transformation permet d'augmenter la distance euclidienne minimale entre deux mots de code en sortie du turbo-codeur.

L'écart cumulé entre deux symboles d'information, ou plus précisément entre deux symboles de modulation associés aux deux symboles d'information, peut notamment être exprimé en terme de distance euclidienne au carré. Bien entendu, d'autres types de distance peuvent être utilisés pour mesurer l'écart, ou la distance, entre symboles d'information.

En d'autres termes, si l'on définit la dispersion Δ($S_i$, $S_j$) entre deux symboles d'information $S_i$ et $S_j$ de GF(q) comme la distance cumulée entre deux symboles d'information avant et après transformation par la fonction T :

[Equation 4]

$$\Delta(S_i, S_j) = D(S_i, S_j) + D(T(S_i), T(S_j))$$

la transformation est choisie de sorte à maximiser la valeur minimale de la dispersion $\Delta(S_i, S_j)$, notée $\Delta_{min}$, ou à tout le moins à obtenir une valeur minimale de la dispersion $\Delta(S_i, S_j)$ supérieure à un seuil de sélection :

[Equation 5]

$$\Delta_{min} = \min_{(S_i, S_j) \in GF(q)^2} \Delta(S_i, S_j)$$

En particulier, la dispersion $\Delta(S_i, S_j)$ entre deux symboles d'information *Si et S$_j$* de GF(q) s'exprime comme la somme du carré de la distance euclidienne entre les symboles de modulation $S_i^m$, $S_j^m$ sur lesquels sont mappés les symboles d'information $S_i$, $S_j$ avant transformation et du carré de la distance euclidienne entre les symboles de modulation $T(S_i)^m$, $T(S_j)^m$ sur lesquels sont mappés les symboles d'information $S_i$, $S_j$ après transformation par la fonction T.

[Equation 6]

$$\Delta(S_i, S_j) = d_{euc}^2(S_i^m, S_j^m) + d_{euc}^2(T(S_i)^m, T(S_j)^m)$$

L'expression de la dispersion donnée par l'équation 6 permet d'obtenir des valeurs entières dans le cas de constellations q-QAM. Toutefois, toute autre expression de la dispersion dont la maximisation ou la minimisation revient à maximiser l'écart cumulé entre les symboles d'information avant et après transformation peut être utilisée.

La fonction de transformation a ainsi pour but d'assurer une valeur élevée de $\Delta_{min}$, i.e. supérieure à un seuil de sélection Th, afin de garantir que si deux symboles d'information sont proches (par exemple mappés sur des symboles de modulation voisins dans la constellation) avant transformation, ils sont éloignés après transformation, et vice versa.

Comme il peut être fastidieux d'énumérer toutes les transformations afin de sélectionner celle qui présente la valeur maximale de $\Delta_{min}$, notamment pour des valeurs de q (cardinalité du corps de Galois) élevées, on propose selon l'invention de sélectionner les valeurs de $\Delta_{min}$ suffisamment grandes, et par exemple supérieure au seuil de sélection Th.

On présente ci-après différents exemples de transformation permettant d'obtenir des valeurs de dispersion minimale $\Delta_{min}$ suffisamment élevées, selon que le cardinal du corps de Galois sur lequel est défini le code, q, et l'ordre de la modulation, p, sont identiques ou différents.

*A) Code et modulation de même ordre : q = p*

Lorsque l'ordre p de la modulation, représentée par une constellation, est égal au cardinal q du corps de Galois auquel appartiennent les symboles d'information, chaque symbole d'information ou de redondance est mappé sur un unique symbole de modulation. En d'autres termes, si l'on considère une chaine de transmission comprenant une étape de turbo-encodage selon l'invention, prenant en entrée des symboles d'information définis sur un corps de Galois GF(q) et délivrant les symboles d'information et des symboles de redondance définis sur le corps de Galois GF(q), et une étape de modulation d'amplitude de type q-QAM, chaque symbole d'information ou de redondance issu de l'étape de turbo-codage est transmis sur un symbole de modulation de la modulation q-QAM, chaque symbole de modulation étant défini sur l'alphabet q (symbole q-aire).

Dans ce cas, la dispersion $\Delta(S_i, S_j)$ entre deux symboles d'information $S_i$ et $S_j$ de GF(q) s'exprime comme :

$$\Delta(S_i, S_j) = d_{euc}^2(S_i^m, S_j^m) + d_{euc}^2(T(S_i)^m, T(S_j)^m)$$

avec :

$$d_{euc}^2(S_i^m, S_j^m) = \left(I_{S_i^m} - I_{S_j^m}\right)^2 + \left(Q_{S_i^m} - Q_{S_j^m}\right)^2$$ le carré de la distance euclidienne entre les symboles de modulation $S_i^m$, $S_j^m$ sur lesquels sont mappés lesdits symboles d'information $S_i$, $S_j$ avant transformation ;

$$d_{euc}^2(T(S_i)^m, T(S_j)^m) = \left(I_{T(S_i)^m} - I_{T(S_j)^m}\right)^2 + \left(Q_{T(S_i)^m} - Q_{T(S_j)^m}\right)^2$$ le carré de la distance euclidienne entre les symboles de modulation $T(S_i)^m$, $T(S_j)^m$ sur lesquels sont mappés lesdits symboles d'information *Si, S$_j$* après transformation ; et

$I_x$ et $Q_x$ les composantes en phase et en quadrature d'un signal x dans la constellation considérée.

Selon un premier exemple de mise en oeuvre, la transformation transforme un couple de symboles d'information destinés à être mappés sur un couple de symboles de modulation dont la distance euclidienne est inférieure à un premier seuil, en un couple de symboles d'information destinés à être mappés sur un couple de symboles de modulation dont la distance euclidienne est supérieure au premier seuil.

En d'autres termes, si le couple de symboles d'information $(S_i, S_j)$ avant transformation est mappé sur un couple de symbole de modulation présentant une faible distance euclidienne, le couple de symboles d'information $(T(S_i), T(S_j))$ après transformation doit être mappé sur un couple de symbole de modulation présentant une forte distance euclidienne, et inversement, de façon à maximiser la dispersion minimale entre les symboles d'information $S_i$, $S_j$.

On présente ci-après un exemple de construction de la fonction de transformation permettant, selon un premier critère, de garantir une valeur minimale pour la dispersion entre les symboles d'information $S_i$, $S_j$.

Selon cet exemple, afin de garantir une dispersion minimale pour chaque couple de symboles d'information $(S_i, S_j)$, il est nécessaire de connaitre la répartition des distances euclidiennes entre l'ensemble des couples de symboles de modulation associés à l'ensemble des couples de symboles d'information dans la constellation considérée. Pour une constellation 64-QAM telle qu'illustrée en figure 5 par exemple, on peut répertorier 33 valeurs différentes de distances entre deux symboles de modulation distincts.

Le tableau ci-après fournit la liste des multiplicités $m(D_i)$ associée à chaque distance $D_i$, c'est-à-dire le nombre de couples de symboles de modulation à chaque distance $D_i$, les distances étant classées dans l'ordre croissant. $D_1$ correspond à la distance entre deux voisins directs et $D_{33}$ à la distance entre deux coins opposés de la constellation :

[Tableau 2]

| $D_i$ | $m(D_i)$ | $D_i$ | $m(D_i)$ | $D_i$ | $m(D_i)$ |
|---|---|---|---|---|---|
| $D_1$ | 112 | $D_{12}$ | 96 | $D_{23}$ | 16 |
| $D_2$ | 98 | $D_{13}$ | 128 | $D_{24}$ | 46 |
| $D_3$ | 96 | $D_{14}$ | 84 | $D_{25}$ | 32 |
| $D_4$ | 168 | $D_{15}$ | 72 | $D_{26}$ | 24 |
| $D_5$ | 72 | $D_{16}$ | 32 | $D_{27}$ | 20 |
| $D_6$ | 80 | $D_{17}$ | 60 | $D_{28}$ | 24 |
| $D_7$ | 140 | $D_{18}$ | 32 | $D_{29}$ | 16 |
| $D_8$ | 120 | $D_{19}$ | 56 | $D_{30}$ | 8 |
| $D_9$ | 64 | $D_{20}$ | 48 | $D_{31}$ | 12 |
| $D_{10}$ | 112 | $D_{21}$ | 48 | $D_{32}$ | 8 |
| $D_{11}$ | 50 | $D_{22}$ | 40 | $D_{33}$ | 2 |

Une première règle de construction de la fonction de transformation consiste à associer les couples dont les distances avant transformation sont au début du tableau avec des couples dont les distances après transformation sont en fin de tableau.

Par exemple, on cherche une valeur maximale de i, notée $i_{max}$, telle que si la distance euclidienne avant transformation entre tous les couples de symboles de modulation associés aux symboles d'information S et S', notée $d_{euc}(S^m, S'^m)$, est inférieure ou égale à $D_{i_{max}}$, leur distance après transformation, notée $d_{euc}(T(S)^m, T(S')^m)$, est strictement supérieure à Dimax. Ceci garantit alors que $\Delta_{min} > D_{i_{max}+1} + D_1$.

Par exemple, pour une modulation 64-QAM telle qu'illustrée en figure 5, $i_{max}$ est égal à 3 : $D_{i_{max}} = D_3$.

La tableau 3 ci-dessous fournit la liste dans multiplicités associées aux distances euclidiennes après transformation pour les couples de symboles d'information S et S' dont la distance euclidienne avant transformation est inférieure à Dimax : $d_{euc}(S^m, S'^m) \leq D_{i_{max}}$.

On observe que tous les couples de symboles de modulation associés à des symboles d'information ont une distance euclidienne strictement supérieure à $Di_{max} = D_3$, puisque les trois premières valeurs de multiplicité sont égales à 0.

[Tableau 3]

| $D_i$ | $m(D_i)$ | $D_i$ | $m(D_i)$ | $D_i$ | $m(D_i)$ |
|---|---|---|---|---|---|
| $D_1$ | 0 | $D_{12}$ | 15 | $D_{23}$ | 5 |

(suite)

| $D_i$ | $m(D_i)$ | $D_i$ | $m(D_i)$ | $D_i$ | $m(D_i)$ |
|---|---|---|---|---|---|
| $D_2$ | 0 | $D_{13}$ | 29 | $D_{24}$ | 12 |
| $D_3$ | 0 | $D_{14}$ | 6 | $D_{25}$ | 7 |
| $D_4$ | 25 | $D_{15}$ | 7 | $D_{26}$ | 3 |
| $D_5$ | 16 | $D_{16}$ | 5 | $D_{27}$ | 8 |
| $D_6$ | 21 | $D_{17}$ | 12 | $D_{28}$ | 4 |
| $D_7$ | 27 | $D_{18}$ | 3 | $D_{29}$ | 6 |
| $D_8$ | 19 | $D_{19}$ | 8 | $D_{30}$ | 2 |
| $D_9$ | 10 | $D_{20}$ | 5 | $D_{31}$ | 1 |
| $D_{10}$ | 22 | $D_{21}$ | 3 | $D_{32}$ | 2 |
| $D_{11}$ | 13 | $D_{22}$ | 9 | $D_{33}$ | 1 |

Selon un deuxième exemple de mise en oeuvre, la transformation transforme un symbole d'information destiné à être mappé sur un symbole de modulation présentant, dans la constellation, un nombre de symboles de modulation voisins inférieur à un nombre déterminé, en un symbole d'information destiné à être mappé sur un symbole de modulation présentant, dans la constellation, un nombre de symboles de modulation voisins supérieur audit nombre déterminé, et inversement, tant que cela est possible.

On présente ci-après un exemple de construction de la fonction de transformation, permettant, selon un deuxième critère, d'optimiser le niveau de protection des symboles d'information.

Si l'on prend, à titre d'exemple, le cas de la constellation 64-QAM illustrée en figure 6, on constate que les 28 symboles de modulation représentés par les points de constellation situés aux coins (points entourés) et sur les bords (points encadrés) de la constellation ont moins de voisins directs que les symboles de modulation situés au centre de la constellation. La constellation confère par conséquent aux symboles d'information ou de redondance mappés sur ces symboles de modulation situés aux coins et sur les bords une meilleure protection, car le nombre de symboles de modulation avec lesquels ces symboles de modulation situés aux coins et sur les bords peuvent être confondus est plus faible.

Par conséquent, si la transformation est construite de telle sorte que les symboles d'information mappés sur des symboles de modulation situés sur les bords et les coins de la constellation avant (respectivement après) transformation se retrouvent dans la partie centrale de la constellation après (respectivement avant) transformation, le nombre total de symboles d'information bénéficiant de cette protection accrue sera doublé par rapport à un schéma de codage sans transformation.

En d'autres termes, dans le cas où les symboles d'information et de redondance issus du turbo-codeur sont associés à une constellation présentant différents niveaux de protection des symboles, une deuxième règle de construction de la transformation peut ainsi être définie.

On note que ces deux exemples de mise en oeuvre de la transformation peuvent être appliqués indépendamment (i.e. de façon individuelle) ou en combinaison.

On présente, à titre d'exemples, deux fonctions de transformation, notées T1 et T2, obtenues en appliquant les deux règles de construction précédentes, et selon lesquelles les symboles d'information et de redondance appartiennent au corps de Galois GF(64) et sont destinés à être mappés sur des symboles de modulation d'une modulation d'amplitude en quadrature 64-QAM telle qu'illustrée en figure 5.

Le mappage des symboles de GF(64) sur la constellation 64-QAM est donné par le tableau suivant, où $b_5b_4b_3b_2b_1b_0$ est la représentation binaire de chaque symbole de GF(64), $b_5$ représentant le bit de poids fort (MSB) et $b_0$ le bit de poids faible (LSB).

[Tableau 4]

| Valeur de Q | $b_5b_3b_1$ | Valeur de I | $b_4b_2b_0$ |
|---|---|---|---|
| +7 | 000 | +7 | 000 |
| +5 | 001 | +5 | 001 |
| +3 | 011 | +3 | 011 |

(suite)

| Valeur de Q | $b_5 b_3 b_1$ | Valeur de I | $b_4 b_2 b_0$ |
|---|---|---|---|
| +1 | 010 | +1 | 010 |
| -1 | 110 | -1 | 110 |
| -3 | 111 | -3 | 111 |
| -5 | 101 | -5 | 101 |
| -7 | 100 | -7 | 100 |

La transformation T1 correspond à une valeur de dispersion minimale $\Delta_{min}$ = 12, et la transformation T2 correspond à la plus grande valeur de dispersion minimale trouvée pour une constellation 64-QAM, $\Delta_{min}$ = 28 :

[Tableau 5]

| x | T1(x) | T2(x) | x | T1(x) | T2(x) | x | T1(x) | T2(x) | x | T1(x) | T2(x) |
|---|---|---|---|---|---|---|---|---|---|---|---|
| 0 | 0 | 15 | 16 | 48 | 7 | 32 | 13 | 11 | 48 | 61 | 41 |
| 1 | 3 | 19 | 17 | 51 | 25 | 33 | 14 | 47 | 49 | 62 | 62 |
| 2 | 6 | 29 | 18 | 54 | 39 | 34 | 11 | 28 | 50 | 59 | 31 |
| 3 | 5 | 0 | 19 | 53 | 9 | 35 | 8 | 50 | 51 | 56 | 33 |
| 4 | 12 | 3 | 20 | 60 | 51 | 36 | 1 | 63 | 52 | 49 | 45 |
| 5 | 15 | 35 | 21 | 63 | 46 | 37 | 2 | 27 | 53 | 50 | 22 |
| 6 | 10 | 12 | 22 | 58 | 37 | 38 | 7 | 10 | 54 | 55 | 49 |
| 7 | 9 | 4 | 23 | 57 | 17 | 39 | 4 | 5 | 55 | 52 | 18 |
| 8 | 24 | 6 | 24 | 40 | 14 | 40 | 21 | 57 | 56 | 37 | 43 |
| 9 | 27 | 8 | 25 | 43 | 2 | 41 | 22 | 44 | 57 | 38 | 60 |
| 10 | 30 | 38 | 26 | 46 | 59 | 42 | 19 | 54 | 58 | 35 | 55 |
| 11 | 29 | 32 | 27 | 45 | 52 | 43 | 16 | 21 | 59 | 32 | 56 |
| 12 | 20 | 1 | 28 | 36 | 34 | 44 | 25 | 58 | 60 | 41 | 13 |
| 13 | 23 | 16 | 29 | 39 | 26 | 45 | 26 | 53 | 61 | 42 | 20 |
| 14 | 18 | 23 | 30 | 34 | 61 | 46 | 31 | 30 | 62 | 47 | 36 |
| 15 | 17 | 24 | 31 | 33 | 48 | 47 | 28 | 42 | 63 | 44 | 40 |

Selon un troisième exemple de mise en oeuvre, le procédé de génération d'un signal met en œuvre une étape de sélection de la transformation parmi plusieurs transformations disponibles, la sélection tenant compte des symboles de redondance et/ou de l'entrelaceur.

En particulier, dans le cas où les première et/ou deuxième règles permettent de construire plusieurs fonctions de transformation équivalentes suivant les critères correspondants, un troisième critère peut être appliqué, pour sélectionner l'une des transformations.

Pour ce faire, pour chaque séquence X comprenant deux ou trois symboles systématiques sur GF(q), on identifie les séquences concurrentes X' comprenant les symboles systématiques concurrents les plus probables, tels que définis précédemment et illustrés en figure 5 pour GF(64). En effet, comme démontré précédemment, ce sont les séquences DC de longueur 2 ou 3 qui sont à l'origine de la distance euclidienne minimale de la modulation codée, qui limite les performances à faible taux d'erreur.

On détermine ensuite la distance euclidienne cumulée des symboles de modulation associés aux symboles de redondance entre chaque séquence transmise et les séquences concurrentes, avant et après transformation :

[Equation 7]

$$d_{euc,p}^2 = \sum_{l=1}^{L} \left[ d^2\left(X_{lp}^m, X_{lp}^{m'}\right) + d^2\left(Y_{lp}^m, Y_{lp}^{m'}\right) \right]$$

où :

L est le nombre de symboles de modulation associés aux symboles systématiques (i.e. L = 2 ou L = 3) ;

$X_{lp}^m, X_{lp}^{m'}$ représentent respectivement les symboles de modulation associés aux I-èmes symboles de parité des séquences X et X' obtenues à partir des symboles d'information ;

$Y_{lp}^m, Y_{lp}^{m'}$ représentent respectivement les symboles de modulation associés aux I-èmes symboles de parité des séquences T(X) et T(X') obtenues à partir des symboles d'information transformés.

L'étape de sélection sélectionne par exemple la transformation T qui conduit au meilleur spectre de distance, où le spectre des distances est composé de l'ensemble des valeurs de distances calculées triées dans l'ordre croissant associée au nombre d'occurrences (multiplicité) pour chaque distance. Le meilleur spectre de distance est celui qui donne la distance minimale la plus grande. En cas d'égalité des distances minimales, on sélectionne par exemple le spectre avec un nombre plus faible d'occurrences de la distance minimale. En cas d'égalité de la multiplicité, on peut regarder la valeur de distance juste supérieure à la distance minimale.

Selon ce troisième exemple de mise en oeuvre, on sélectionne ainsi la transformation la plus avantageuse en termes de distance euclidienne cumulée.

On note que si la fonction de transformation présente deux composantes, l'une mise en oeuvre avant le premier codage et l'autre avant le deuxième codage, avant ou après entrelacement, les critères ci-dessus s'appliquent de façon à optimiser globalement la fonction de transformation.

*B) Code et modulation d'ordre différent : q > p*

Lorsque l'ordre p de la modulation, représentée par une constellation, est inférieur au cardinal q du corps de Galois auquel appartiennent les symboles d'information, chaque symbole d'information ou de redondance est mappé sur plusieurs symboles de modulation. En d'autres termes, si l'on considère une chaine de transmission comprenant une étape de turbo-encodage selon l'invention, prenant en entrée des symboles d'information définis sur un corps de Galois GF(q), et délivrant les symboles d'information et des symboles de redondance définis sur le corps de Galois GF(q), et une étape de modulation d'ordre p, chaque symbole d'information ou de redondance issu de l'étape de turbo-codage est transmis sur $n$ symboles de modulation, chaque symbole de modulation étant défini sur l'alphabet p (symbole p-aire).

L'introduction d'une fonction de transformation permet ainsi d'améliorer les performances de correction à faible taux d'erreur lorsque les symboles du corps de Galois sur lequel est défini le code, q, sont transmis à l'aide de n symboles d'une constellation d'ordre plus faible p : $q = p^n$.

A titre d'exemple, chaque symbole d'information ou de redondance issu du turbo-codeur, défini sur GF(256), est transmis sur deux symboles de modulation d'une modulation 16-QAM (q = 256, p = 16, n = 2), définis dans l'alphabet 0 à 15, ou chaque symbole d'information ou de redondance issu du turbo-codeur, défini sur GF(64), est transmis sur trois symboles de modulation QPSK (q = 64, p = 4, n = 3), définis dans l'alphabet 0 à 3.

Dans ce cas, chaque symbole d'information ou de redondance de GF(q) peut être représenté par un ensemble de $n$ symboles de modulation associés à une constellation d'ordre $p$ (par exemple $p$-QAM).

Dans ce cas, la dispersion $\Delta(S_i, S_j)$ entre deux symboles d'information $S_i$ et $S_j$ de GF(q) s'exprime comme :

[Equation 8]

$$\Delta\big(S_i, S_j\big) = D\big(S_i, S_j\big) + D\big(T(S_i), T(S_j)\big) =$$

$$\Delta\big(S_i, S_j\big) = \sum_{k=1}^{n} d_{euc}^2\big(S_{i,k}^m, S_{j,k}^m\big) + \sum_{k=1}^{n} d_{euc}^2\big(T(S_i)_k^m, T(S_j)_k^m\big)$$

$$= \sum_{k=1}^{n} \left[\left(I_{S_{i,k}^m} - I_{S_{j,k}^m}\right)^2 + \left(Q_{S_{i,k}^m} - Q_{S_{j,k}^m}\right)^2\right]$$

$$+ \sum_{k=1}^{n} \left[\left(I_{T(S_i)_k^m} - I_{T(S_j)_k^m}\right)^2 + \left(Q_{T(S_i)_k^m} - Q_{T(S_j)_k^m}\right)^2\right]$$

avec :

$S^m_{i,k}$ respectivement $S^m_{j,k}$, pour k allant de 1 à n, les *n* symboles de modulation associés au symbole d'information $S_i$, respectivement $S_j$, avant transformation, $T(S_i)_k^m$, respectivement $T(S_j)_k^m$, pour k allant de 1 à n, les *n* symboles de modulation associés au symbole d'information $S_i$, respectivement *Sj,* après transformation,

$I_x$ et $Q_x$ les composantes en phase et en quadrature d'un signal x dans la constellation considérée.

Le terme de distance entre deux symboles de GF(q) se décompose donc en *n* termes, chacun des *n* termes représentant une distance euclidienne dans l'espace de la constellation d'ordre *p.*

On présente ci-après différents exemples de mise en oeuvre permettant d'obtenir une valeur de dispersion minimale $\Delta_{min}$ suffisamment élevée, i.e. supérieure à un seuil de sélection, dans ce cas particulier où q > p :

$$\Delta_{min} = \min_{(S_i, S_j) \in GF(q)^2} \Delta\big(S_i, S_j\big).$$

Selon un premier exemple de mise en œuvre, la transformation minimise le nombre de termes nuls dans l'équation 8 de la dispersion *Δ(S_i, S_j).*

Plus précisément, chaque expression de la distance *D(S_i, S_j)* contient *n* termes de distance euclidienne dans l'espace d'une constellation à *p* signaux. On cherche par conséquent à minimiser le nombre de symboles *p*-aires, parmi les n symboles de modulation associés à chaque symbole d'information de GF(*q*), identiques avant et après transformation.

Pour ce faire, la transformation associe des couples de symboles d'information de GF(q) ayant beaucoup de symboles *p*-aires en commun, avec des couples de symboles d'information ayant peu de symboles p-aires en commun, et vice versa.

En d'autres termes, la transformation transforme un couple de symboles d'information destinés à être mappé chacun sur n symboles de modulation p-aires, le nombre de symboles p-aires en commun entre les deux ensembles de n symboles de modulation p-aires étant supérieur à un deuxième seuil, en un couple de symboles d'information destinés à être mappé chacun sur n symboles de modulation p-aires, le nombre de symboles p-aires en commun entre ces deux ensembles de n symboles de modulation p-aires étant inférieur au deuxième seuil, et inversement.

A titre d'exemple, si l'on considère un turbo-code défini sur le corps de Galois GF(64), pour lequel chaque symbole d'information ou de redondance est transmis sur trois symboles de modulation QPSK (i.e. q = 64, p = 4, n = 3), deux symboles d'information distincts dans GF(64) peuvent différer de un, deux ou trois symboles de modulation distincts dans la constellation QPSK.

Ainsi, si le symbole d'information 19 (010011) défini dans GF(64) est destiné à être mappé sur les trois symboles de modulation QPSK 103 et le symbole d'information 62 (111110) est destiné à être mappé sur les trois symboles de modulation QPSK 332, les deux symboles d'information 19 et 62 diffèrent, dans la constellation QPSK, de trois symboles de modulation ($1 \neq 3$, $0 \neq 3$, $3 \neq 2$). L'expression de la distance entre les symboles d'information, D(19,62) ne contient aucun terme nul.

Si le symbole d'information 55 (110111) est destiné à être mappé sur les trois symboles de modulation 313, et le symbole d'information 62 (111110) est destiné être mappé sur les trois symboles de modulation 332, les deux symboles d'information diffèrent, dans la constellation QPSK, de deux symboles de modulation (3=3, 1≠3, 3≠2). L'expression de la distance entre les symboles d'information, D(55,62) contient donc un terme nul.

Si le symbole d'information 63 (111111) est destiné à être mappé sur les trois symboles de modulation 333, et le symbole d'information 62 (111110) est destiné être mappé sur les trois symboles de modulation 332, les deux symboles d'information diffèrent, dans la constellation QPSK, d'un seul symbole de modulation (3=3, 3=3, 3*2). L'expression de la distance entre les symboles d'information, D(63,62) contient donc deux termes nuls.

Parmi les $C_{64}^2 = 2016$ combinaisons possibles de couples de symboles d'information de GF(64), on détermine ainsi :

- 864 couples n'ayant aucun symbole QPSK en commun lorsque les symboles d'information sont représentés dans la constellation QPSK,
- 864 couples ayant un symbole QPSK en commun lorsque les symboles d'information sont représentés dans la constellation QPSK,
- 288 couples ayant deux symboles QPSK en commun lorsque les symboles d'information sont représentés dans la constellation QPSK.

La transformation proposée permet d'associer en priorité les couples de symboles d'information ayant, dans la constellation QPSK, deux symboles QPSK en commun avec les couples de symboles d'information n'ayant, dans la constellation QPSK, aucun symbole QPSK en commun, puis les couples de symboles d'information ayant, dans la constellation QPSK, un symbole QPSK en commun avec les couples de symboles d'information n'ayant, dans la constellation QPSK, aucun symbole QPSK en commun.

Par exemple, la transformation T3 proposée ci-après dans le tableau 7 permet de transformer les 288 couples de symboles d'information ayant deux symboles QPSK en commun, avant transformation, en 288 couples n'ayant aucun symbole QPSK en commun, après transformation, et de transformer 48 couples de symboles d'information ayant un symbole QPSK en commun, avant transformation, en 48 couples n'ayant aucun symbole QPSK en commun, après transformation. Les 864 - 48 = 816 couples de symboles d'information restants gardent un symbole QPSK en commun après transformation.

Le mappage sur la constellation QPSK est donné par le tableau 6 suivant, où $b_1 b_0$ est la représentation binaire associée à chaque symbole de modulation QPSK, $b_1$ représentant le bit de poids fort (MSB) et $b_0$ le bit de poids faible (LSB).

[Tableau 6]

| Valeur de Q | $b_1$ | Valeur de I | $b_0$ |
|---|---|---|---|
| +1 | 0 | +1 | 0 |
| -1 | 1 | -1 | 1 |

[Tableau 7]

| x | T3(x) | x | T3(x) | x | T3(x) | x | T3(x) |
|---|---|---|---|---|---|---|---|
| 0 | 0 | 16 | 30 | 32 | 39 | 48 | 57 |
| 1 | 21 | 17 | 11 | 33 | 50 | 49 | 44 |
| 2 | 42 | 18 | 52 | 34 | 13 | 50 | 19 |
| 3 | 63 | 19 | 33 | 35 | 24 | 51 | 6 |
| 4 | 27 | 20 | 5 | 36 | 60 | 52 | 34 |
| 5 | 14 | 21 | 16 | 37 | 41 | 53 | 55 |
| 6 | 49 | 22 | 47 | 38 | 22 | 54 | 8 |
| 7 | 36 | 23 | 58 | 39 | 3 | 55 | 29 |
| 8 | 45 | 24 | 51 | 40 | 10 | 56 | 20 |
| 9 | 56 | 25 | 38 | 41 | 31 | 57 | 1 |

(suite)

| x | T3(x) | x | T3(x) | x | T3(x) | x | T3(x) |
|----|-------|----|-------|----|-------|----|-------|
| 10 | 7 | 26 | 25 | 42 | 48 | 58 | 46 |
| 11 | 18 | 27 | 12 | 43 | 37 | 59 | 59 |
| 12 | 54 | 28 | 40 | 44 | 17 | 60 | 15 |
| 13 | 35 | 29 | 61 | 45 | 4 | 61 | 26 |
| 14 | 28 | 30 | 2 | 46 | 43 | 62 | 53 |
| 15 | 9 | 31 | 23 | 47 | 62 | 63 | 32 |

Selon un deuxième exemple de mise en œuvre, le procédé de génération d'un signal selon l'invention comprend une étape de sélection de la transformation parmi plusieurs transformations disponibles, la sélection maximisant les termes non nuls dans l'équation 8 de la dispersion $\Delta(S_i, S_j)$.

En particulier, dans le cas où l'exemple de mise en œuvre proposé précédemment permet de construire plusieurs fonctions de transformation équivalentes, une étape de sélection peut être mise en oeuvre, permettant de sélectionner la fonction de transformation qui maximise les valeurs non nulles des termes $\left[\left(I_{S_{i,k}^m} - I_{S_{j,k}^m}\right)^2 + \left(Q_{S_{i,k}^m} - Q_{S_{j,k}^m}\right)^2\right] + \left[\left(I_{T(S_i)_k^m} - I_{T(S_j)_k^m}\right)^2 + \left(Q_{T(S_i)_k^m} - Q_{T(S_j)_k^m}\right)^2\right]$

Un tel critère permet en effet de garantir que des symboles $p$-aires proches avant transformation seront éloignés après transformation.

*5.4 Performances*

On présente ci-après quelques résultats de simulation, permettant de mesurer l'effet de l'introduction d'une transformation sur les performances de correction d'un turbo-code, indépendamment de l'effet de l'entrelacement.

Les figures 7A à 7C illustrent le taux d'erreur (FER) en fonction du rapport signal à bruit ($E_b/N_0$) pour différentes simulations, lorsque l'ordre de la modulation et du turbo-code sont identiques.

Pour obtenir ces résultats, on considère :

- la structure de la figure 2A, selon laquelle les symboles d'information entrant sur le premier codeur C1 21A ne sont ni entrelacés, ni transformés, et les symboles d'information entrant sur le deuxième codeur C2 22A sont entrelacés, puis transformés ;
- chaque codeur C1 21A, C2 22A met en oeuvre le même code élémentaire à un seul élément mémoire, tel qu'illustré en figure 3A ;
- le rendement du turbo-code est 1/3 ;
- la longueur des messages numériques d'entrée est de K = 900 symboles d'information ;
- les symboles d'information sont définis sur GF(64) ;
- la modulation est une modulation 64-QAM ;
- la longueur des messages numériques d'entrée exprimée en bits est $K_b$ = K×6 = 5400 bits d'information.

Pour les résultats illustrés en figures 7A et 7B, les paramètres de réglage du code élémentaire sont par exemple : $a_1$=31, $a_2$=5 et $a_3$=18, et pour les résultats illustrés en figure 7C, les paramètres de réglage du code élémentaire sont par exemple : $a_1$=41, $a_2$=2 et $a_3$=0, et le code est construit en utilisant le polynôme primitif P(D)=1+$D^2$+$D^3$+$D^5$+$D^6$.

Différentes transformations ont été testées :

- configuration 1 : la transformation est la fonction identité (il n'y a pas de transformation). Dans ce cas, pour une modulation 64-QAM, on a :

$$\Delta_{min} = 2 \times \min_{(S_i, S_j) \in GF(q)^2} d_{euc}^2(S_i^m, S_j^m) = 8$$

- configuration 2: la transformation T1 correspond à une valeur de dispersion minimale $\Delta_{min}$ = 12 ;
- configuration 3 : la transformation T2 correspond à une valeur de dispersion minimale $\Delta_{min}$ = 28, soit la plus grande valeur de $\Delta_{min}$ trouvée pour une constellation 64-QAM.

Les transformations T1 et T2 pour la constellation 64-QAM de la figure 5 sont présentées dans le tableau 5.

Une première simulation a consisté à simuler un turbo-code dont la fonction d'entrelacement est la fonction identité. Autrement dit, les séquences de symboles d'information avant et après entrelacement sont identiques. Dans ce cas, aucun gain de performance lié à l'entrelacement (« gain d'entrelacement ») n'est attendu.

Les résultats de cette première simulation sont illustrés en figure 7A.

Lorsqu'aucune transformation n'est appliquée (courbe 71A), les performances de correction du turbo-code sont similaires à celles du code convolutif élémentaire pour lequel on répète la transmission des symboles de parité.

Lorsqu'une transformation est insérée avant codage par le deuxième codeur C2 22A, par exemple la transformation T1 (courbe 72A) ou la transformation T2 (courbe 72B) un gain de codage est observé, qui augmente avec la valeur de la dispersion minimale $\Delta_{min}$.

Une deuxième simulation a consisté à simuler un turbo-code dont la fonction d'entrelacement est une fonction aléatoire (encore appelée entrelacement uniforme). Il s'agit d'un entrelaceur probabiliste qui permet d'estimer le gain d'entrelacement moyen du turbo-code, indépendamment d'un schéma particulier d'entrelacement. L'entrelaceur est tiré de manière aléatoire pour chaque message transmis. Les courbes de taux d'erreurs ainsi obtenues représentent les performances du code moyennées sur l'ensemble des entrelaceurs possibles.

Les résultats de cette deuxième simulation sont illustrés en figure 7B.

A la différence des performances de la figure 7A, on peut ici observer la présence d'un gain de codage lié à l'entrelacement. On observe également le phénomène de taux d'erreur plancher (en anglais « error floor »), caractéristique des turbo-codes lorsque l'entrelacement n'est pas optimisé. La position du plancher d'erreur sur les courbes 72A (pas de transformation), 72B (avec la transformation T1) ou 72C (avec la transformation T2) est donnée par la borne de l'union du turbo-code, selon l'équation 1.

On observe sur la figure 7B que l'introduction d'une transformation permet d'abaisser le plancher d'erreur et d'améliorer le pouvoir de correction à faible taux d'erreur du turbo-code, et ceci d'autant plus que le paramètre de dispersion minimale $\Delta_{min}$ associé à la transformation est élevé. Ceci confirme l'augmentation de la distance euclidienne cumulée minimale du turbo-code avec la maximisation du paramètre de dispersion minimale $\Delta_{min}$.

Une troisième simulation a consisté à simuler un turbo-code dont la fonction d'entrelacement est une fonction d'entrelacement classique, par exemple de type ARP (en anglais « Almost Regular Interleaver »).

Les résultats de cette troisième simulation sont illustrés en figure 7C.

On observe sur la figure 7C les mêmes phénomènes que sur la figure 7B.

En particulier, comme les paramètres $a_1$=41, $a_2$=2 et $a_3$=0 de chaque code élémentaire (C1, C2) ont été modifiés, le turbo-code obtenu ne possède pas de bonne propriétés de distances et présente un taux d'erreur plancher naturellement élevé sans transformation (courbe 71C). On peut observer que l'utilisation de la transformation T2, en termes de dispersion, permet d'abaisser ce taux d'erreur plancher d'environ 2 décades (courbes 73C).

Un phénomène similaire a aussi été observé pour d'autres codes élémentaires sur GF(64) avec les mêmes transformations, ainsi que pour des codes définis sur GF(16), associés à une modulation 16-QAM.

La figure 8 illustre le taux d'erreur (FER) en fonction du rapport signal à bruit ($E_b/N_0$) pour différentes simulations, lorsque l'ordre de la modulation et du turbo-code sont différents.

Pour obtenir ces résultats, on considère :

- la structure de la figure 2A, selon laquelle les symboles d'information entrant sur le premier codeur C1 21A ne sont ni entrelacés, ni transformés, et les symboles d'information entrant sur le deuxième codeur C2 22A sont entrelacés, puis transformés ;
- chaque codeur C1 21A, C2 22A met en oeuvre le même code élémentaire à un seul élément mémoire, tel qu'illustré en figure 3A ;
- la longueur des messages numériques d'entrée est de K = 900 symboles d'information ;
- les symboles d'information sont définis sur GF(64) ;
- la modulation est une modulation QPSK ;
- la longueur des messages numériques d'entrée exprimée en bits est $K_b$ = K×6 = 5400 bits d'information.

Pour les résultats illustrés en figure 8, les paramètres de réglage du code élémentaire sont a1=31, a2=5 et a3=18 et le code est construit en utilisant le polynôme primitif P(D)=1+$D^2$+$D^3$+$D^5$+$D^6$.

Différentes transformations ont été testées :

- configuration 1 : la transformation est la fonction identité (il n'y a pas de transformation) ;

- configuration 2 : la transformation T3 correspond à une valeur de dispersion minimale $\Delta_{min}$ = 16.

La transformation T3 est décrite dans le tableau 7.

Le turbo-code ainsi obtenu a été simulé pour une transmission sur canal gaussien, en utilisant un entrelaceur aléatoire. On observe sur la figure 8 les courbes de performances sans mise en œuvre d'une transformation (courbe 81) et avec mise en oeuvre de la transformation T3 (courbe 82), et on constate que l'introduction de la transformation permet également dans ce contexte d'abaisser significativement le plancher d'erreur et d'améliorer le pouvoir de correction à faible taux d'erreur du turbo-code.

On note que dans les simulations ci-dessus, on a considéré que les codeurs C1 et C2 mettent en œuvre le même code élémentaire, par exemple celui illustré en figure 3A. Bien entendu, ces codeurs peuvent mettre en oeuvre des codes différents, et notamment des codes présentant un pouvoir de correction différent. En particulier, une seule sortie systématique est prévue dans le turbo-encodeur.

*55 Structure*

On présente finalement, en relation avec la figure 9, la structure simplifiée d'un turbo-codeur selon au moins un mode de réalisation décrit ci-dessus.

Un tel turbo-encodeur comprend au moins une mémoire 91 comprenant une mémoire tampon, au moins une unité de traitement 92, équipée par exemple d'une machine de calcul programmable ou d'une machine de calcul dédiée, par exemple un processeur P, et pilotée par le programme d'ordinateur 93, mettant en œuvre des étapes du procédé de génération d'un signal selon au moins un mode de réalisation de l'invention.

A l'initialisation, les instructions de code du programme d'ordinateur 93 sont par exemple chargées dans une mémoire RAM avant d'être exécutées par le processeur de l'unité de traitement 92.

Le processeur de l'unité de traitement 92 met en œuvre des étapes du procédé de génération d'un signal décrit précédemment, selon les instructions du programme d'ordinateur 93, pour :

- coder un ensemble de symboles d'information (soit les symboles d'information entrants, soit les symboles d'information transformés) en utilisant un premier code, délivrant un premier ensemble de symboles de redondance,
- entrelacer l'ensemble de symboles d'information (soit les symboles d'information entrants, soit les symboles d'information transformés), délivrant un ensemble de symboles d'information entrelacés,
- coder l'ensemble de symboles d'information entrelacés (soit les symboles d'information entrants, soit les symboles d'information transformés) en utilisant un deuxième code, délivrant un deuxième ensemble de symboles de redondance,
- appliquer une transformation bijective aux symboles d'information (soit les symboles d'information entrants, soit les symboles d'information entrelacés), avant et/ou après l'entrelacement.

**Revendications**

1. Procédé de génération d'un signal, destiné à être mis en oeuvre par un dispositif de génération de signal, le procédé comprenant une étape de turbo-codage d'un ensemble de symboles d'information délivrant d'une part lesdits symboles d'information et d'autre part des symboles de redondance, les symboles d'information appartenant à un corps de Galois de cardinal q, noté GF(q), avec q>2, mettant en oeuvre, pour l'obtention des symboles de redondance :

   - un codage (21A, 21B) dudit ensemble de symboles d'information par un premier codeur, délivrant un premier ensemble de symboles de redondance,
   - un entrelacement (23A, 23B) dudit ensemble de symboles d'information, délivrant un ensemble de symboles d'information entrelacés,
   - un codage (22A, 22B) dudit ensemble de symboles d'information entrelacés par un deuxième codeur, délivrant un deuxième ensemble de symboles de redondance, **caractérisé en ce que** ladite étape de turbo-codage met également en oeuvre une transformation (24A, 24B) bijective desdits symboles d'information, mise en oeuvre avant et/ou après ledit entrelacement, ladite transformation modifiant la valeur d'au moins deux desdits symboles d'information préalablement au codage desdits symboles d'information par le premier et/ou le deuxième codeur.

2. Procédé selon la revendication précédente, **caractérisé en ce que** ladite transformation génère une dispersion minimale $\Delta_{min}$ entre deux symboles d'information $S_i$, $S_j$ parmi lesdits symboles d'information supérieure à un seuil de sélection, telle que :

$$\Delta_{min} = \min \Delta(S_i, S_j)$$

avec :

$$\Delta(S_i, S_j) = D(S_i, S_j) + D(T(S_i), T(S_j))$$

$D(S_i, S_j)$ la distance entre lesdits symboles d'information $S_i$, $S_j$ avant transformation,
$D(T(S_i), T(S_j))$ la distance entre lesdits symboles d'information $S_i$, $S_j$ après transformation par la fonction T.

3. Procédé selon l'une quelconque des revendications précédentes, **caractérisé en ce qu'**il met en oeuvre une étape de mappage des symboles d'information et de redondance sur des symboles de modulation associés à une constellation d'ordre p, un symbole d'information ou de redondance étant mappé sur au moins un symbole de modulation, et **en ce que** ladite transformation tient compte de ladite constellation.

4. Procédé selon la revendication 3 **caractérisé en ce que**, l'ordre p de la constellation étant égal au cardinal q du corps de Galois auquel appartiennent lesdits symboles d'information, chaque symbole d'information ou de redondance est mappé sur un unique symbole de modulation.

5. Procédé selon les revendications 2 et 4, **caractérisé en ce que** la dispersion entre deux symboles d'information $Si$, $S_j$ s'exprime sous la forme :

$$\Delta(S_i, S_j) = d_{euc}^2(S_i^m, S_j^m) + d_{euc}^2(T(S_i)^m, T(S_j)^m)$$

avec :

$$d_{euc}^2(S_i^m, S_j^m) = \left(I_{S_i^m} - I_{S_j^m}\right)^2 + \left(Q_{S_i^m} - Q_{S_j^m}\right)^2$$ le carré de la distance euclidienne entre les symboles de modulation $S_j^m$, $S_j^m$ sur lesquels sont mappés lesdits symboles d'information $S_i$, $S_j$ avant transformation ;

$$d_{euc}^2(T(S_i)^m, T(S_j)^m) = \left(I_{T(S_i)^m} - I_{T(S_j)^m}\right)^2 + \left(Q_{T(S_i)^m} - Q_{T(S_j)^m}\right)^2$$ le carré de la distance euclidienne entre les symboles de modulation $T(S_i)^m$, $T(S_j)^m$ sur lesquels sont mappés lesdits symboles d'information $S_i$, $S_j$ après transformation ;
$I_x$ et $Q_x$ les composantes en phase et en quadrature d'un signal x dans la constellation considérée.

6. Procédé selon l'une quelconque des revendications 4 et 5, **caractérisé en ce que** ladite transformation transforme un couple de symboles d'information destinés à être mappés sur un couple de symboles de modulation dont la distance euclidienne est inférieure à un premier seuil, en un couple de symboles d'information destinés à être mappés sur un couple de symbole de modulation dont la distance euclidienne est supérieure audit premier seuil.

7. Procédé selon l'une quelconque des revendications 4 à 6, **caractérisé en ce que** ladite transformation transforme un symbole d'information destiné à être mappé sur un symbole de modulation présentant, dans la constellation, un nombre de symboles de modulation voisins inférieur à un nombre déterminé, en un symbole d'information destiné à être mappé sur un symbole de modulation présentant, dans la constellation, un nombre de voisins supérieur audit nombre déterminé.

8. Procédé selon la revendication 3, **caractérisé en ce que**, l'ordre $p$ de la constellation étant inférieur au cardinal q du corps de Galois auquel appartiennent lesdits symboles d'information, chaque symbole d'information ou de redondance est mappé sur $n$ symboles de modulation, avec $n \geq 2$.

9. Procédé selon les revendications 2 et 8, **caractérisé en ce que** la dispersion entre deux symboles d'information $Si$, $S_j$ s'exprime sous la forme :

$$\Delta\big(S_i, S_j\big) = D\big(S_i, S_j\big) + D\big(T(S_i), T(S_j)\big)$$

avec :

$$D\big(S_i, S_j\big) = \sum_{k=1}^{n} d_{euc}^2\big(S_{i,k}^m, S_{j,k}^m\big) = \sum_{k=1}^{n}\left[\big(I_{S_{i,k}^m} - I_{S_{j,k}^m}\big)^2 + \big(Q_{S_{i,k}^m} - Q_{S_{j,k}^m}\big)^2\right]$$

$$D\big(T(S_i), T(S_j)\big) = \sum_{k=1}^{n} d_{euc}^2\big(T(S_i)_k^m, T(S_j)_k^m\big)$$
$$= \sum_{k=1}^{n}\left[\big(I_{T(S_i)_k^m} - I_{T(S_j)_k^m}\big)^2 + \big(Q_{T(S_i)_k^m} - Q_{T(S_j)_k^m}\big)^2\right]$$

$S^m_{i,k}$ respectivement $S^m_{j,k}$, pour k allant de 1 à n, les *n* symboles de modulation associés au symbole d'information *Si,* respectivement *Sj,* avant transformation,

$T(S_i)^m k$, respectivement $T(S_j)^m k$, pour k allant de 1 à n, les *n* symboles de modulation associés au symbole d'information *Si,* respectivement *Sj,* après transformation,

$I_x$ et $Q_x$ les composantes en phase et en quadrature d'un signal x dans la constellation considérée.

**10.** Procédé selon la revendication 9, **caractérisé en ce que** ladite transformation minimise le nombre de termes nuis dans l'expression de la dispersion $\Delta(S_i, S_j)$.

**11.** Procédé selon l'une quelconque des revendications 9 et 10, **caractérisé en ce qu'**il comprend une étape de sélection de ladite transformation parmi plusieurs transformations disponibles, ladite sélection maximisant la valeur des termes non nuis dans l'expression de la dispersion $\Delta(S_i, S_j)$.

**12.** Dispositif de génération d'un signal, comprenant un turbo-encodeur apte à encoder un ensemble de symboles d'information et délivrer d'une part lesdits symboles d'information et d'autre part des symboles de redondance, les symboles d'information appartenant à un corps de Galois de cardinal q, noté GF(q), avec q>2, ledit turbo-encodeur comprenant :

- un premier codeur (21A, 21B) pour coder ledit ensemble de symboles d'information, délivrant un premier ensemble de symboles de redondance,
- un entrelaceur (23A, 23B) pour entrelacer ledit ensemble de symboles d'information, délivrant un ensemble de symboles d'information entrelacés,
- un deuxième codeur (22A, 22B) pour coder ledit ensemble de symboles d'information entrelacés, délivrant un deuxième ensemble de symboles de redondance, **caractérisé en ce que** ledit turbo-encodeur comprend également un processeur pour appliquer une transformation bijective (24A, 24B) auxdits symboles d'information, mise en oeuvre avant et/ou après ledit entrelaceur, ladite transformation modifiant la valeur d'au moins deux desdits symboles d'information préalablement au codage desdits symboles d'information par le premier et/ou le deuxième codeur.

**13.** Programme d'ordinateur comportant des instructions pour la mise en oeuvre d'un procédé selon la revendication 1 lorsque ce programme est exécuté par un processeur.

**Patentansprüche**

**1.** Verfahren zur Erzeugung eines Signals mittels einer Vorrichtung zur Signalerzeugung, wobei das Verfahren einen Schritt des Turbocodierens einer Menge von Informationssymbolen umfasst, der einerseits die Informationssymbole und andererseits Redundanzsymbole liefert, wobei die Informationssymbole zu einem Galois-Körper der Kardinalität q, als GF(q) bezeichnet, mit q>2 gehören, das zum Erhalten der Redundanzsymbole Folgendes durchführt:

- Codieren (21A, 21B) der Menge von Informationssymbolen durch einen ersten Codierer, das eine erste Menge von Redundanzsymbolen liefert,
- Verschachteln (23A, 23B) der Menge von Informationssymbolen, das eine Menge verschachtelter Informationssymbole liefert,
- Codieren (22A, 22B) der Menge verschachtelter Informationssymbole durch einen zweiten Codierer, das eine zweite Menge von Redundanzsymbolen liefert, **dadurch gekennzeichnet, dass** der Schritt des Turbocodierens außerdem eine bijektive Transformation (24A, 24B) der Informationssymbole durchführt, die vor und/oder nach dem Verschachteln durchgeführt wird, wobei die Transformation den Wert von mindestens zwei der Informationssymbole vor dem Codieren der Informationssymbole durch den ersten und/oder den zweiten Codierer durchgeführt wird.

2. Verfahren nach dem vorhergehenden Anspruch, **dadurch gekennzeichnet, dass** die Transformation eine minimale Streuung $\Delta_{min}$ zwischen zwei Informationssymbolen $S_i$, $S_j$ aus den Informationssymbolen oberhalb einer Auswahlschwelle erzeugt, so dass:

$$\Delta_{min} = \min \Delta(S_i, S_j)$$

mit:

$$\Delta(S_i, S_j) = D(S_i,S_j) + D(T(S_i),T(S_j))$$

$D(S_i,S_j)$ dem Abstand zwischen den Informationssymbolen $S_i$, $S_j$ vor der Transformation,
$D(T(S_i),T(S_j))$ dem Abstand zwischen den Informationssymbolen $S_i$, $S_j$ nach der Transformation durch die Funktion T.

3. Verfahren nach einem der vorhergehenden Ansprüche, **dadurch gekennzeichnet, dass** es einen Schritt des Abbildens der Informations- und Redundanzsymbole auf Modulationssymbole durchführt, die mit einer Konstellation der Ordnung p assoziiert sind, wobei ein Informations- oder Redundanzsymbol auf mindestens ein Modulationssymbol abgebildet wird, und dadurch, dass die Transformation die Konstellation berücksichtigt.

4. Verfahren nach Anspruch 3, **dadurch gekennzeichnet, dass** die Ordnung p der Konstellation gleich der Kardinalität q des Galois-Körpers ist, zu dem die Informationssymbole gehören, wobei jedes Informations- oder Redundanzsymbol auf ein eindeutiges Modulationssymbol abgebildet wird.

5. Verfahren nach Anspruch 2 und 4, **dadurch gekennzeichnet, dass** die Streuung zwischen zwei Informationssymbolen $S_i$, $S_j$ sich ausdrückt in der Form:

$$\Delta(S_i, S_j) = d_{euc}^2(S_i^m, S_j^m) + d_{euc}^2(T(S_i)^m, T(S_j)^m)$$

mit:

$$d_{euc}^2(S_i^m, S_j^m) = (I_{S_i^m} - I_{S_j^m})^2 + (Q_{S_i^m} - Q_{S_j^m})^2$$ dem Quadrat des euklidischen Abstands zwischen den Modulationssymbolen $S_i^m, S_j^m$, auf die die Informationssymbole $S_i, S_j$ vor der Transformation abgebildet werden;

$$d_{euc}^2(T(S_i)^m, T(S_j)^m) = (I_{T(S_i)^m} - I_{T(S_j)^m})^2 + (Q_{T(S_i)^m} - Q_{T(S_j)^m})^2$$ dem Quadrat des euklidischen Abstands zwischen den Modulationssymbolen $T(S_i)^m$, $T(S_j)^m$, auf die die Informationssymbole $S_i, S_j$ nach der Transformation abgebildet werden;
$I_x$ und $Q_x$, den Inphase- und Quadraturkomponenten eines Signals x in der betrachteten Konstellation.

6. Verfahren nach einem der Ansprüche 4 und 5, **dadurch gekennzeichnet, dass** die Transformation ein Paar von Informationssymbolen transformiert, die dazu bestimmt sind, auf ein Paar von Modulationssymbolen abgebildet zu werden, deren euklidischer Abstand über dem ersten Schwellenwert liegt.

7. Verfahren nach einem der Ansprüche 4 bis 6, **dadurch gekennzeichnet, dass** die Transformation ein Informationssymbol, das dazu bestimmt ist, auf ein Modulationssymbol abgebildet zu werden, das in der Konstellation eine Anzahl benachbarter Modulationssymbole aufweist, die kleiner als eine bestimmte Anzahl ist, in ein Informationssymbol transformiert, das dazu bestimmt ist, auf ein Modulationssymbol abgebildet zu werden, das in der Konstellation eine Anzahl von Nachbarn aufweist, die über der bestimmten Anzahl liegt.

8. Verfahren nach Anspruch 3, **dadurch gekennzeichnet, dass**, da die Ordnung p der Konstellation kleiner ist als die Kardinalität q des Galois-Körpers, zu dem die Informationssymbole gehören, jedes Informations- oder Redundanzsymbol auf n Modulationssymbole mit n≥2 abgebildet wird.

9. Verfahren nach Anspruch 2 und 8, **dadurch gekennzeichnet, dass** die Streuung zwischen zwei Informationssymbolen $S_i$, $S_j$ sich ausdrückt in der Form:

$$\Delta\left(S_i, S_j\right) = D\left(S_i, S_j\right) + D\left(T(S_i), (T(S_j)\right)$$

mit:

$$D\left(S_i, S_j\right) = \sum_{k=1}^{n} d_{euc}^2\left(S_{i,k}^m, S_{j,k}^m\right) = \sum_{k=1}^{n}\left[\left(I_{S_{i,k}^m} - I_{S_{j,k}^m}\right)^2 + \left(Q_{S_{i,k}^m} - Q_{S_{j,k}^m}\right)^2\right]$$

$$D(T(S_i), T(S_j)) = \sum_{k=1}^{n} d_{euc}^2(T(S_i)_k^m, T(S_j)_k^m)$$

$$= \sum_{k=1}^{n}\left[\left(I_{T(S_i)_k^m} - I_{T(S_j)_k^m}\right)^2 + \left(Q_{T(S_i)_k^m} - Q_{T(S_j)_k^m}\right)^2\right]$$

$S_{i,k}^m$ bzw. $S_{j,k}^m$, für k von 1 bis n, wobei die n Modulationssymbole vor der Transformation mit dem Informationssymbol $S_i$ bzw. $S_j$ assoziiert sind, $T(S_i)_k^m$ bzw. $T(S_j)_k^m$, für k von 1 bis n, wobei die n Modulationssymbole nach der Transformation mit dem Informationssymbol $S_i$ bzw. $S_j$ assoziiert sind, $I_x$ und $Q_x$, den Inphase- und Quadraturkomponenten eines Signals x in der betrachteten Konstellation.

10. Verfahren nach Anspruch 9, **dadurch gekennzeichnet, dass** die Transformation die Anzahl der Null-Terme im Streuungsausdruck $\Delta(S_i, S_j)$ minimiert.

11. Verfahren nach einem der Ansprüche 9 und 10, **dadurch gekennzeichnet, dass** es einen Schritt des Auswählens der Transformation aus mehreren verfügbaren Transformationen umfasst, wobei das Auswählen den Wert der Nichtnull-Terme im Streuungsausdruck $\Delta(S_i, S_j)$ minimiert.

12. Vorrichtung zur Erzeugung eines Signals, umfassend einen Turbocodierer, der dazu fähig ist, eine Menge von Informationssymbolen zu codieren und einerseits die Informationssymbole und andererseits Redundanzsymbole zu liefern, wobei die Informationssymbole zu einem Galois-Körper der Kardinalität q, als GF(q) bezeichnet, mit q>2 gehören, wobei der Turbocodierer umfasst:

   - einen ersten Codierer (21A, 21B) zum Codieren der Menge von Informationssymbolen, der eine erste Menge von Redundanzsymbolen liefert,
   - einen Verschachtler (23A, 23B) zum Verschachteln der Menge von Informationssymbolen, der eine Menge verschachtelter Informationssymbole liefert,
   - einen zweiten Codierer (22A, 22B) zum Codieren der Menge verschachtelter Informationssymbole, der eine zweite Menge von Redundanzsymbolen liefert,

**dadurch gekennzeichnet, dass** der Turbocodierer außerdem einen Prozessor zum Anwenden einer bijektiven Transformation (24A, 24B) auf die Informationssymbole umfasst, die vor und/oder nach dem Verschachtler durchgeführt wird, wobei die Transformation den Wert von mindestens zwei der Informationssymbole vor der Codierung der Informationssymbole durch den ersten und/oder den zweiten Codierer verändert.

13. Computerprogramm, umfassend Anweisungen für die Durchführung eines Verfahrens nach Anspruch 1, wenn dieses Programm durch einen Prozessor ausgeführt wird.

**Claims**

1. Method for generating a signal, intended to be implemented by a signal generation device, the method comprising a step of turbo-coding a set of information symbols delivering said information symbols, on the one hand, and redundant symbols, on the other hand, the information symbols belonging to a Galois field of cardinal q, denoted GF(q), with q>2, implementing the following in order to obtain the redundant symbols:

   - coding (21A, 21B) said set of information symbols by way of a first encoder, delivering a first set of redundant symbols,
   - interleaving (23A, 23B) said set of information symbols, delivering a set of interleaved information symbols,
   - coding (22A, 22B) said set of interleaved information symbols by way of a second encoder, delivering a second set of redundant symbols, **characterized in that** said turbo-coding step also implements a bijective transformation (24A, 24B) of said information symbols, implemented before and/or after said interleaving, said transformation modifying the value of at least two of said information symbols prior to said information symbols being coded by the first and/or the second encoder.

2. Method according to the preceding claim, **characterized in that** said transformation generates a minimum dispersion $\Delta_{min}$ between two information symbols $S_i$, $S_j$ from among said information symbols greater than a selection threshold, such that:

$$\Delta_{min} = \min \Delta(S_i, S_j)$$

with:

$$\Delta(S_i, S_j) = D(S_i, S_j) + D(T(S_i), T(S_j))$$

$D(S_i, S_j)$ the distance between said information symbols $S_i$, $S_j$ before transformation,
$D(T(S_i), T(S_j))$ the distance between said information symbols $S_i$, $S_j$ after transformation by the function T.

3. Method according to either one of the preceding claims, **characterized in that** it implements a step of mapping the information symbols and redundant symbols onto modulation symbols associated with a constellation of order p, an information symbol or redundant symbol being mapped onto at least one modulation symbol, and **in that** said transformation takes account of said constellation.

4. Method according to Claim 3, **characterized in that**, with the order p of the constellation being equal to the cardinal q of the Galois field to which said information symbols belong, each information symbol or redundant symbol is mapped onto a single modulation symbol.

5. Method according to Claims 2 and 4, **characterized in that** the dispersion between two information symbols $S_i$, $S_j$ is expressed in the form:

$$\Delta(S_i, S_j) = d^2_{euc}(S_i^m, S_j^m) + d^2_{euc}(T(S_i)^m, T(S_j)^m)$$

with:

$$d_{euc}^2\left(S_i^m, S_j^m\right) = \left(I_{S_i^m} - I_{S_j^m}\right)^2 + \left(Q_{S_i^m} - Q_{S_j^m}\right)^2$$ the square of the Euclidean distance between the modulation symbols $S_i^m$, $S_j^m$ onto which said information symbols $S_i$, $S_j$ are mapped before transformation;

$$d_{euc}^2\left(T(S_i)^m, T(S_j)^m\right) = \left(I_{T(S_i)^m} - I_{T(S_j)^m}\right)^2 + \left(Q_{T(S_i)^m} - Q_{T(S_j)^m}\right)^2$$ the square of the Euclidean distance between the modulation symbols $T(S_i)^m$, $T(S_j)^m$ onto which said information symbols $S_i$, $S_j$ are maped after transformation;

$I_x$ and $Q_x$ the phase and quadrature components of a signal x in the constellation under consideration.

6. Method according to either one of Claims 4 and 5, **characterized in that** said transformation transforms a pair of information symbols intended to be mapped onto a pair of modulation symbols whose Euclidean distance is below a first threshold into a pair of information symbols intended to be mapped onto a pair of modulation symbols whose Euclidean distance is above said first threshold.

7. Method according to any one of Claims 4 to 6, **characterized in that** said transformation transforms an information symbol intended to be mapped onto a modulation symbol having, in the constellation, a number of neighbouring modulation symbols below a determined number into an information symbol intended to be mapped onto a modulation symbol having, in the constellation, a number of neighbours above said predetermined number.

8. Method according to Claim 3, **characterized in that**, with the order $p$ of the constellation being lower than the cardinal q of the Galois field to which said information symbols belong, each information symbol or redundant symbol is mapped onto $n$ modulation symbols, with $n \geq 2$.

9. Method according to Claims 2 and 8, **characterized in that** the dispersion between two information symbols $S_i$, $S_j$ is expressed in the form:

$$\Delta\left(S_i, S_j\right) = D\left(S_i, S_j\right) + D\left(T(S_i), T(S_j)\right)$$

with:

$$D\left(S_i, S_j\right) = \sum_{k=1}^{n} d_{euc}^2\left(S_{i,k}^m, S_{j,k}^m\right) = \sum_{k=1}^{n}\left[\left(I_{S_{i,k}^m} - I_{S_{j,k}^m}\right)^2 + \left(Q_{S_{i,k}^m} - Q_{S_{j,k}^m}\right)^2\right]$$

$$D\left(T(S_i), T(S_j)\right) = \sum_{k=1}^{n} d_{euc}^2\left(T(S_i)_k^m, T(S_j)_k^m\right)$$
$$= \sum_{k=1}^{n}\left[\left(I_{T(S_i)_k^m} - I_{T(S_j)_k^m}\right)^2 + \left(Q_{T(S_i)_k^m} - Q_{T(S_j)_k^m}\right)^2\right]$$

$S_{i,k}^m$, respectively $S_{j,k}^m$, for k ranging from 1 to n, the $n$ modulation symbols associated with the information symbol $S_i$, respectively $S_j$, before transformation,
$T(S_i)_k^m$, respectively $T(S_j)_k^m$, for k ranging from 1 to n, the $n$ modulation symbols associated with the information symbol $S_i$, respectively $S_j$, after transformation,
$I_x$ and $Q_x$ the phase and quadrature components of a signal x in the constellation under consideration.

10. Method according to Claim 9, **characterized in that** said transformation minimizes the number of zero terms in the expression of the dispersion $\Delta(S_i, S_j)$.

11. Method according to either one of Claims 9 and 10, **characterized in that** it comprises a step of selecting said transformation from among multiple available transformations, said selection maximizing the value of the non-zero terms in the expression of the dispersion $\Delta(S_i, S_j)$.

**12.** Device for generating a signal, comprising a turbo-encoder able to encode a set of information symbols and deliver said information symbols, on the one hand, and redundant symbols, on the other hand, the information symbols belonging to a Galois field of cardinal q, denoted GF(q), with q>2, said turbo-encoder comprising:

- a first encoder (21A, 21B) for coding said set of information symbols, delivering a first set of redundant symbols,
- an interleaver (23A, 23B) for interleaving said set of information symbols, delivering a set of interleaved information symbols,
- a second encoder (22A, 22B) for coding said set of interleaved information symbols, delivering a second set of redundant symbols,

**characterized in that** said turbo-encoder also comprises a processor for implementing a bijective transformation (24A, 24B) on said information symbols, implemented before and/or after said interleaver, said transformation modifying the value of at least two of said information symbols prior to said information symbols being coded by the first and/or the second encoder.

**13.** Computer program comprising instructions for implementing a method according to Claim 1 when this program is executed by a processor.

[Fig. 1]

[Fig. 2A]

[Fig. 2B]

[Fig. 3A]

[Fig. 3B]

[Fig. 4]

— : DC-2    — — : DC-3    ····· : DC-4 tronquée    ······ : DC-4

[Fig. 5]

[Fig. 6]

[Fig. 7A]

[Fig. 7B]

[Fig. 7C]

[Fig. 8]

[Fig. 9]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TOSHIKI et al.** Capacity-Approaching Non-Binary Turbo Codes: A Hybrid Design Based on EXIT Charts and Union Bounds. *IEEE Access,* 2018, vol. 6

- **RAMI et al.** Design of Low-Complexity Convolutional Codes over GF(q). *IEEE Globecom,* 2018